(19) Europäisches Patentamt

European Patent Office

Office européen des brevets

(11) **EP 0 698 824 B1**

(12) **EUROPEAN PATENT SPECIFICATION**

(45) Date of publication and mention
of the grant of the patent:
**18.10.2000 Bulletin 2000/42**

(51) Int Cl.⁷: **G03F 7/20**

(21) Application number: **95401955.0**

(22) Date of filing: **25.08.1995**

(54) **Pattern formation method and method and apparatus for production of a semiconductor device using said method**

Mustererzeugungsverfahren und Verfahren und Apparat zur Herstellung einer Halbleitervorrichtung unter Verwendung von diesem Verfahren

Méthode de formation de motifs et méthode et appareil de fabrication d'un dispositif semi-conducteur utilisant ladite méthode

(84) Designated Contracting States:
**BE DE FR GB NL**

(30) Priority: **26.08.1994 JP 20261994**

(43) Date of publication of application:
**28.02.1996 Bulletin 1996/09**

(73) Proprietor: **SONY CORPORATION**
**Tokyo (JP)**

(72) Inventor: **Ogawa, Tohru, c/o Sony Corporation**
**Tokyo (JP)**

(74) Representative: **Thévenet, Jean-Bruno et al**
**Cabinet Beau de Loménie**
**158, rue de l'Université**
**75340 Paris Cédex 07 (FR)**

(56) References cited:
**EP-A- 0 485 062      EP-A- 0 651 291**
**WO-A-94/20883      DE-A- 4 303 028**
**US-A- 5 309 198**

• **PATENT ABSTRACTS OF JAPAN vol. 017 no. 340 (E-1389) ,28 June 1993 & JP-A-05 047639 (CANON INC) 26 February 1993, & US-A-5 363 170 (MURAKI MASATO) 8 November 1994**

**Description**

BACKGROUND OF THE INVENTION

1. Field of the Invention

The present invention relates to a pattern formation method and a method and apparatus for production of a semiconductor device using that method, more particularly the invention relates to a method of exposure which enables a good pattern to be formed without the problem of a secondary peak even if using a phase shifting mask.

2. Description of the Related Art

At present, in the research and development of semiconductor integrated circuits, effort is being made to develop devices of a design rule of the sub-half micron order. In developing such devices, photolithography is indispensable. It is not too much to say that the resolution performance of the exposure devices used in photolithography, the so-called "reduction, projection, and exposure devices", determines the success or failure of research and development into semiconductor devices and the feasibility of mass production.

Conventionally, the resolution performance of reduction projection and exposure devices has been improved by enlarging the numerical aperture of the reduction projection lens or shortening the exposure wavelength based on the following Rayleigh criterion:

$$R = k1 \times \lambda/NA$$

where,

R: resolution
$\lambda$: Exposure wavelength
NA: Numerical aperture
k1: Process coefficient

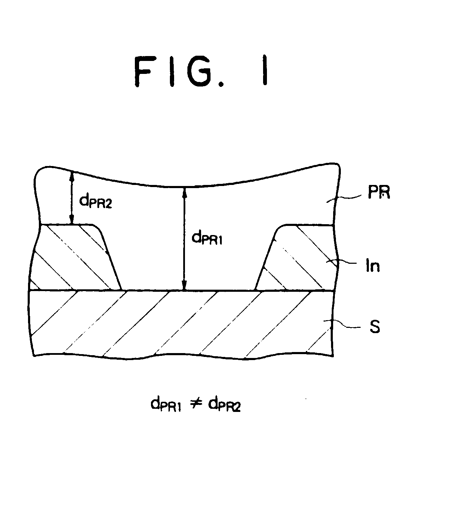

However, in the fabrication of a semiconductor device, there are step differences caused by the topography, wafer flatness, etc. of the semiconductor device, and therefore securing of the depth of focus is also an important parameter at the same time as the resolution performance. The dimensional precision of the resist pattern in the photolithography step at the time of fabrication of a semiconductor device is generally ±5 percent. In an actual device, as shown in Fig. 1, there is always unevenness in the surface of the semiconductor substrate S. For example, there is a convex portion In of polycrystalline silicon etc. As a result, the pattern of the resist PR is not formed on the same focal plane. For this reason, the dimensions of the pattern of the resist PR differ between the upper portion and the lower portion of a step difference. Of course, this becomes more conspicuous the finer the pattern in a case where a stepper of the same wavelength and same numerical aperture is used. This tendency is seen in common for all types of resist.

The depth of focus becomes smaller in primary proportion to the exposure wavelength and in inverse proportion to the square of the numerical aperture. At the mass production stage, a depth of focus of about 1.5 μm is necessary. For this reason, there are restrictions in order to satisfy both of the resolution performance and the depth of focus considered necessary.

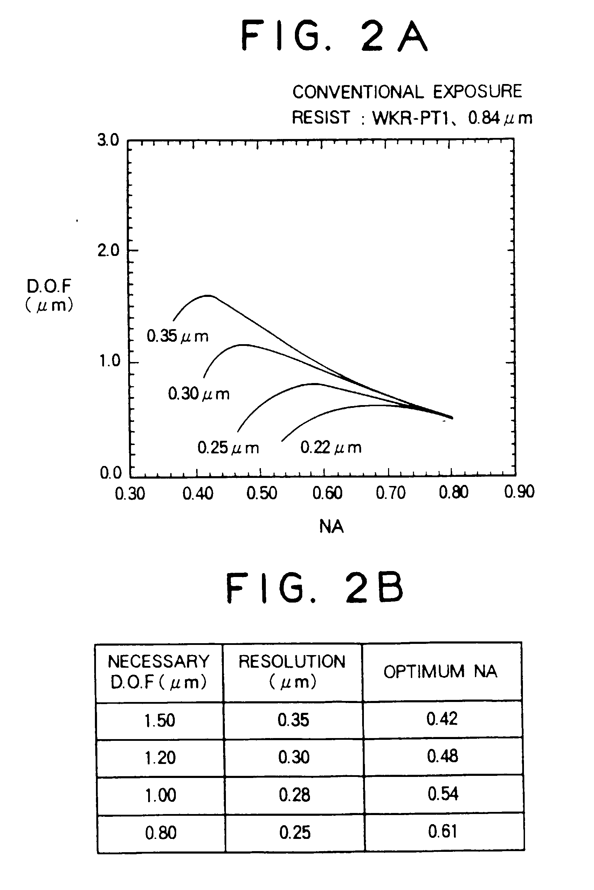

Figures 2A and 2B show the dependency on the numerical aperture when the resolution performance of the depth of focus (D.O.F) in KrF excimer laser lithography, which is the most advanced exposure, is used as a parameter. As will be understood from the figures, the highest resolution which is obtained while satisfying the needed depth of focus of 1.5 μm is about 0.35 μm. Accordingly, it is extremely difficult to resolve a line width of 0.35 μm or less with a depth of focus of 1.5 μm or more. Some sort of technique for enlarging the depth of focus is necessary.

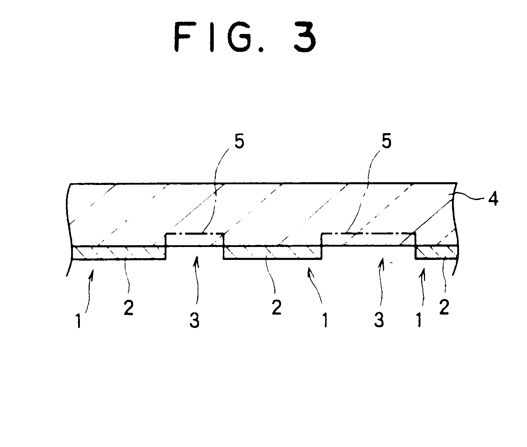

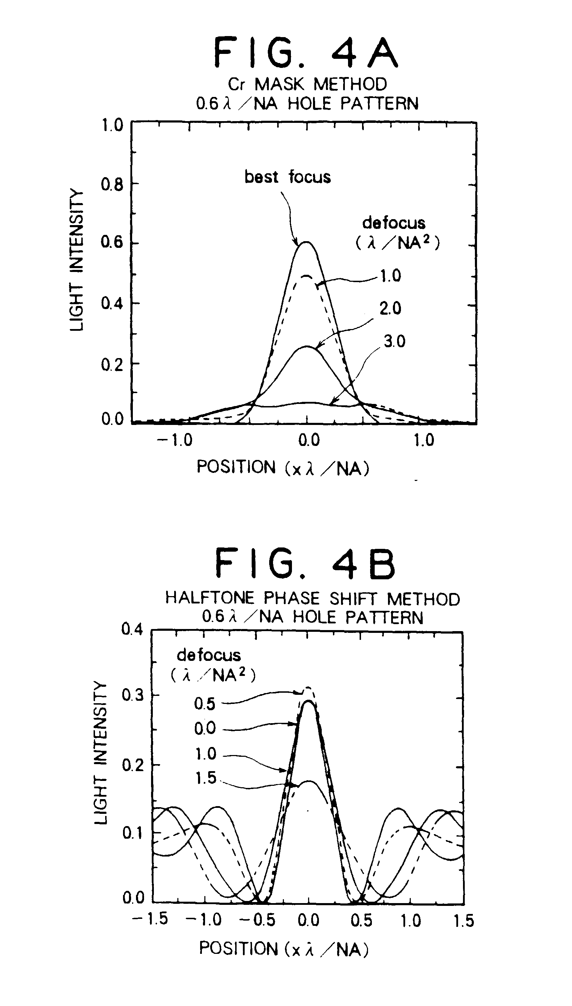

In response to such a request, in recent years, the halftone type phase shift method has been proposed. This exposure method is an extremely powerful method for improving the resolution and depth of focus of an isolated pattern such as a contact hole. In the halftone type phase shift method, as shown in Fig. 3, a semitransparent Cr, $Si_x N_y$, $SiO_x N_y$, $Mo_x Si_y$ film, or the like having a transmittance with respect to the exposure light of about several percentage to about 20 percent, that is, allowing passage of a fine amount of exposure light therethrough, is used as the halftone film 2 corresponding to the dark portions 1. In the bright portions 3, both of the film 2 and transparent substrate (with a concave portion 5 formed therein) or only the film 2 is etched and made to act as a mask. At this time, by setting the phase difference between the bright portions 3 and the dark portions 1 formed by the semitransparent film to 180°, as shown in Fig. 4B, the gradient of the distribution of the intensity of the light in an isolated pattern (for example, a hole pattern of 0.6 λ/NA) can be made sharp. Note that, Fig. 4A shows the distribution of the intensity of the light in an isolated pattern using a conventional chromium mask.

In the design of this phase shifting mask, the transmittance of the halftone film 2 is an important factor. Namely, so as to make the gradient of the distribution of the intensity of the light in an isolated pattern sharper, it is sufficient to raise the transmittance of the halftone film 2. However, by raising the transmittance, the light shielding effect by the halftone film 2 is weakened, and the resist ends up exposed over its entire surface.

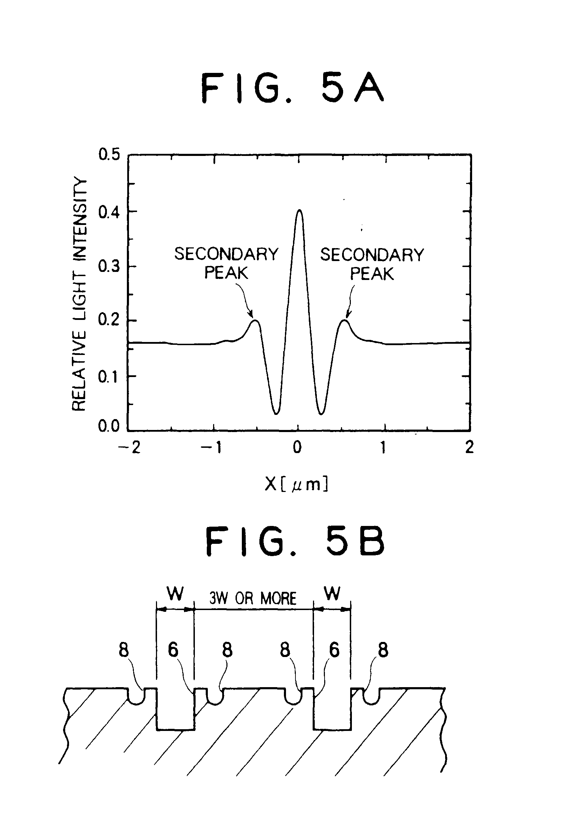

Also, usually, at the time of formation of a pattern, as shown in Fig. 5A, a secondary peak called a side lobe is generated due to the adjacency effect on both sides of the desired pattern position in the distribution of the intensity of the light irrespective of the light shielding position. The secondary peak becomes stronger when the halftone transmittance is raised. As shown in Fig.5B, even in a so-called completely isolated contact hole wherein, for example, when the design dimension of the hole pattern 6 is defined as W, the distance between the adjoining patterns is 3W or more, the peripheral portion becomes "gouged" in shape (numeral 8 part). With a shape as shown in Fig. 5B, there is concern that the diameter of the contact hole will be enlarged in the etching step.

Further, when it is intended to apply the halftone phase shifting mask method to a so-called periodic pattern portion having a high pattern density, the secondary peak becomes stronger due to interference between adjoining patterns, that is, the mutual adjacency effect, at the periodic pattern portion having the high pattern density.

Accordingly, when it is intended to form a device pattern by using the halftone phase shifting mask method, the design and a CAD process must be carried out with sufficient consideration given to the distance between patterns. This places a tremendous load on the design and CAD process and prevents practical application.

Document JP-5 047 639 discloses an illuminator and a projection aligner using the same. It comprises an optical integrator, made of plural bar lenses. Said integrator receives a plurality of beams, resulting from a single beam separated into several beams of different optical path lengths, thereby forming a secondary light source. A condensing optical system turns a secondary beam from the secondary light source toward a surface to be illuminated.

Document DE-4 303 028 discloses a projection exposure apparatus and a pattern forming method for use therewith. The exposure apparatus has an effective source, a mask, a projection lens and an optical filter. The mask is illuminated with the light from the effective source having a substantially annular illumination distribution.

Document EP-0 485 062 discloses a method of forming a pattern and projection exposure apparatus. The pupil of a projection lens of the projection apparatus has mounted thereon an optical filter having a complex amplitude transmittance distribution expressed as $T(r) = \cos(2\pi\beta r^2 - \theta/2)$ as a function of a radical coordinate r normalised by the maximum radius of the pupil.

Document US-5 309 198 discloses a light exposure system, comprising an illumination optical system for illuminating the first object, a projection optical system for projecting the pattern on the first object onto the second object, a stage device for two-dimensionally moving the second object while holding the second object, a reference member mounted on the stage device, a detecting device for detecting light from the reference member, and a measuring device for carrying out a predetermined measurement, based on an output of the detecting device.

So as to solve the above-mentioned problems, intensive study is currently underway in various areas on how to enlarge the depth of focus without making the adjacency effect more conspicuous and without placing a heavy load on the design of the mask. However, no effective exposure method for enlarging the depth of focus without suffering from the above-described problems has yet been found. Accordingly, it is essential to quickly establish an exposure technique for enlarging the depth of focus without making the adjacency effect conspicuous and without placing a heavy load on the design of the mask.

At the present time, when a practical depth of focus cannot be obtained in the fabrication of a device, pattern formation has been carried out by using the multilayer resist method, electron beam exposure method, etc. However, a sufficiently satisfactory effect has not been obtained.

Accordingly, it is essential to quickly establish an exposure technique for enlarging the depth of focus without making the adjacency effect conspicuous, without placing a heavy load on the design of the mask, and without exerting an adverse influence on the aberration and other imaging characteristics by a method other than that mentioned above.

SUMMARY OF THE INVENTION

The present invention was made in consideration of the above-described situation and has as an object thereof to provide a pattern formation method and a method and apparatus for production of a semiconductor device using the same which, when fabricating a semiconductor device or the like, decides on the method of enlarging the depth of focus so that a stable resist pattern can be formed well even if the mask pattern thereof is fine and thereby enables a good resist patterning.

The present invention provides a method for enlarging the depth of focus at the time of fabrication of a semiconductor device without exerting an adverse influence upon the aberration and imaging characteristic by using a halftone phase shifting mask having any pattern density, even if the mask pattern of the semiconductor device is fine.

The above-described object is achieved by this. This will be understood by analyzing the optical system of the exposure device. Namely, the present invention was obtained by the following discovery by the present inventor.

The depth of focus was enlarged without exerting an adverse influence upon the aberration and other imaging characteristics by using a halftone phase shifting mask having any pattern density by using the following means:

(1) So as to enable the use of the halftone phase shifting mask method for a design pattern having any pattern density without placing a tremendous load on the design and CAD process, it is sufficient if use may be made of the so-called periodic pattern portion having a high pattern density. Such a periodic pattern portion having a high pattern density is formed by interference of adjoining patterns, so it is sufficient if the secondary peak in the distribution of the intensity of the light due to the mutual adjacency effect can be reduced.

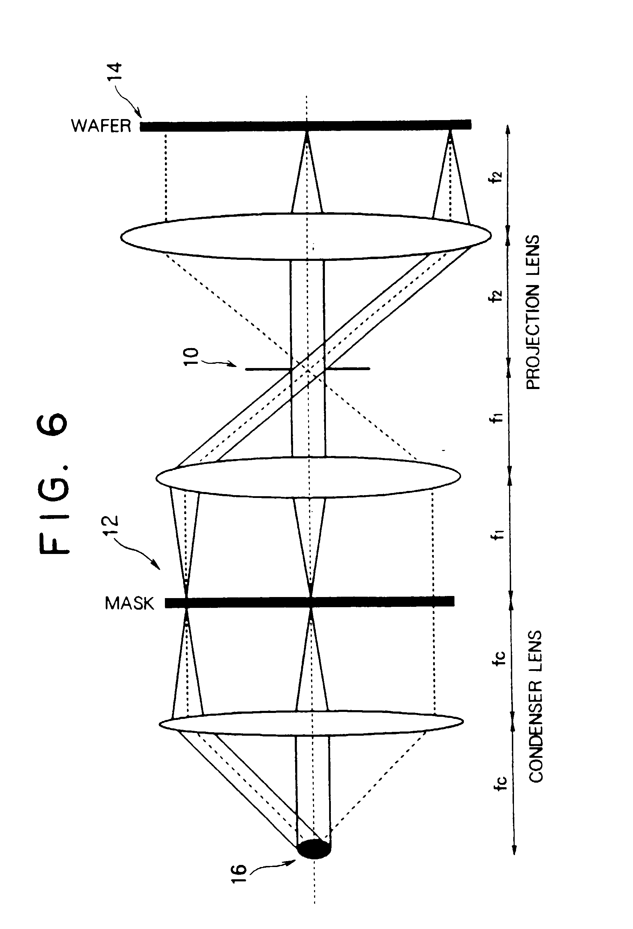

(2) The distribution of the intensity of the light depends upon the distribution of the intensity of the light in the effective light source of the exposure device. Namely, the optical projection system of the exposure device, that is, the "stepper", as shown in Fig. 6, has a whole system diaphragm 10 arranged at first group and second group of focal planes. It is a dual telecentric imaging system and is an afocal system as a whole. Namely, the mask surface 12 and pupil surface (substantially equal to the diaphragm 10) and the pupil surface and wafer surface 14 are in a Fourier transformation relationship. Also, the light from the illumination optical system for illuminating the mask is shown developed completely as plane waves. Due to the afocal characteristic, individual plane waves correspond to individual light emission points of the secondary light source (also called the effective light source) 16, that is, the fly's-eye lens.

(3) Based on the characteristic shown by (2), if the respective coordinate systems of the mask surface, pupil surface, and the wafer surface are defined as $(x, y)$, $(\xi, \eta)$, and $(\alpha, \beta)$ and the focal distances of the first group and second group are defined as $f1$ and $f2$ and, also, the transmission function of the mask is defined as $o(x, y)$, the amplitude distribution $f(\xi, \eta, \theta_1, \theta_2)$ on the pupil surface can be represented by the following equation:

$$f(\xi, \eta, \theta_1, \theta_2) = \iint o(x,y)\, \exp\{jk(\sin\theta_1 x + \sin\theta_2 y)\}$$

$$\exp\{jk\, (\xi x + \eta y)\, /f1\}\,dxdy = \iint o(x,y)\, \exp[jk\{(\sin\theta_1 + \xi/f1)x + (\sin\theta_2 + \eta/f1)y\}]\,dxdy \qquad (1)$$

where, $\theta_1$ and $\theta_2$ are made the incident angles of the plane wave incident upon the mask in the x and y directions.

When defining the amplitude distribution on the wafer surface as $g(\alpha, \beta, \theta_1, \theta_2)$ and defining the pupil function as $p(\xi, \eta)$, the following equation stands:

$$g(\alpha,\beta,\theta_1,\theta_2)$$

$$= \iint f(\xi,\eta,\theta_1,\theta_2)\exp\{-jk(\alpha\xi+\beta\eta)\}d\xi d\eta$$

$$= \iint \iint o(x,y)p(\xi,\eta)$$

$$\exp[jk\{(\sin\theta_1 + \xi/f1)x + (\sin\theta_2 + \eta/f2)y\}]$$

$$\exp\{-jk(\alpha\xi+\beta\eta)\}dxdyd\xi d\eta \qquad (2)$$

The distribution of intensity $I(\alpha, \beta, \theta_1, \theta_2)$ of the plane wave incident on the wafer surface by $\theta_1$ and $\theta_2$ can be represented by the following equation:

$$I(\alpha, \beta\, \theta_1, \theta_2) = g(\alpha, \beta, \theta_1, \theta_2)g^*(\alpha, \beta, \theta_1, \theta_2) \qquad (3)$$

Therefore, the overall distribution of intensity $I(\alpha, \beta)$ becomes the superposition of the plane waves, and therefore if the weighting function is defined as $W(\theta_1, \theta_2)$, the following equation stands:

$$I(\alpha, \beta) = \iint w(\theta_1,\theta_2)I(\alpha, \beta, \theta_1, \theta_2)\, d\theta_1\, d\theta_2 \qquad (4)$$

Were, when assuming "the mask is a lattice pattern of equal intervals parallel to the y-axis", the transmission function o (x, y) of the mask can be represented by the following equation defining the mask frequency as $\omega$:

$$o(x,y) = o(x) = \sum_{n=-\infty}^{\infty} a_n \exp(jn\omega x)$$

$$-\infty < n < +\infty \qquad (5)$$

Accordingly, the amplitude distribution f ($\xi$, $\eta$, $\theta_1$, $\theta_2$) on the pupil surface can be represented by the following equation:

$$f(\xi,\eta,\theta_1,\theta_2)$$

$$= \iint \sum a_n \exp(jn\omega x)$$

$$\exp[jk\{(\sin\theta_1+\xi/f1)x+(\sin\theta_2+\eta/f1)y\}]dxdy$$

$$= \sum_n a_n \delta(\sin\theta_1+n\omega/k+\xi/f1)\delta(\sin\theta_2+\eta/f1) \qquad (6)$$

When the wave plane aberration on the pupil surface is W ($\xi$, $\eta$), the amplitude distribution g ($\alpha$, $\beta$, $\theta_1$, $\theta_2$) on the wafer surface can be represented by the following equation:

$$g(\alpha,\beta,\theta_1,\theta_2)$$

$$= \sum_n a_n \iint \delta(\sin\theta_1+n\omega/k+\xi+f1)\delta(\sin\theta_2+\eta/f1)$$

$$p_n(\theta_1,\theta_2)\exp\{jW(\xi,\eta)\}\exp\{-jk(\xi\alpha+\eta\beta)\}d\xi d\eta$$

$$= \sum_n a_n p_n(\theta_1,\theta_2)\exp[jW\{-f1(\sin\theta_1+n\,\omega/k),-f1\sin\theta_2\}]$$

$$\exp[jk(\sin\theta_1+n\omega/k)(f1/f2)\alpha]$$

$$\exp[jk(f1/f2)\beta\sin\theta2] \qquad (7)$$

Here, as apparent from the aforesaid equation (7), the spectrum distribution of the object on the pupil surface is the sum of $\delta$-functions. Accordingly, a decision whether or not the n-th diffracted light enters into the pupil is clear. Therefore, use is made of a vignetting factor Pn for deciding whether the diffracted light should or should not enter into the pupil in equation (8).

$$p_n(\theta_1, \theta_2) = 1 \textit{ spectrum exit in pupil plane } 0 \textit{ otherwise} \qquad (8)$$

From the above, the distribution of intensity I ($\alpha$, $\beta$, $\theta_1$, $\theta_2$) of the individual plane waves on the wafer surface can be represented by the following equation:

$$I(\alpha, \beta, \theta_1, \theta_2)$$

$$= \sum_n \sum_m a_n a_m p_n(\theta_1, \theta_2) p_m(\theta_1, \theta_2)$$

$$\exp[jW(-f1(\sin\theta_1 + n\omega/k), -f1\sin\theta_2)$$

$$-jW(-f1(\sin\theta_1 + m\omega/k, -f1\sin\theta_2)]$$

$$\exp[j(n-m)(f1/f2)\omega\alpha] \qquad (9)$$

In the case of ideal imaging ignoring aberration etc., the following equation stands:

$$W(\xi, \eta) = 0 \qquad (10)$$

Therefore, the distribution of intensity I ($\alpha$, $\beta$, $\theta_1$, $\theta_2$) of the individual plane waves can be represented by the following equation:

$$I(\theta_1, \theta_2)$$

$$= \sum_n a_n^2 p_n(\theta_1, \theta_2) + 2\sum \sum a_n a_m p_n(\theta_1, \theta_2)$$

$$p_m(\theta_1, \theta_2)\cos[(f1/f2)(n-m)\omega\alpha] \qquad (11)$$

That is, the above-described equation is weighted in accordance with the ratio of intensities of the respective points of the fly's-eye lens and superposed to find the overall distribution of the intensity of the light I ($\alpha$, $\beta$) on the wafer surface.

(4) The above-described equation (11) is a basic equation when performing ideal imaging. Below, the above-described equation (11) is actually analyzed. So as to obtain a strict solution, it is necessary to superpose all orders of the diffracted light, but even if attention is paid to only the 0-th order and 1-th order light beams in actuality, the higher order diffracted light is rejected by the pupil at the problematic fine line widths and therefore generality of the results of analysis is not lost.

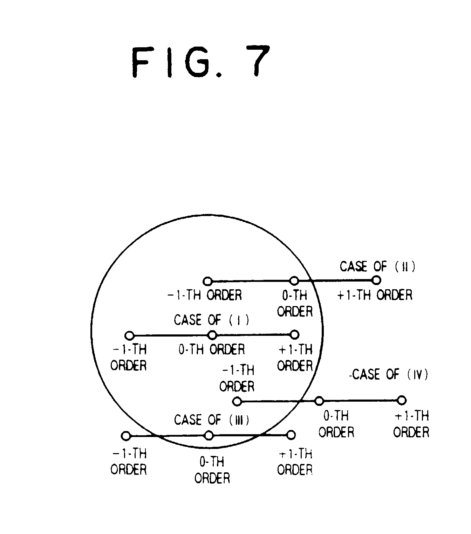

(5) When considering only the 0-th order and $\pm$1-th order light beams, due to the positional relationship of the rejection of the diffracted light shown in Fig. 7, only the four following cases exist in equation (12):

(I)     $P_0 = P_1 = P_{-1} = 1$

$$I(\theta_1,\theta_2) = [a_0+2a_1\cos\{(f1/f2)\omega\alpha\}]^2 \qquad (12)$$

(II) $\quad P_0=P_1=1,\ P_{-1}=0$ or $P_0=P_{-1}=0,\ P_1=0$

$$I(\theta_1,\theta_2) = a_0^2+a_1^2+2a_0a_1\cos\{(f1/f2)\ \omega\alpha\} \qquad (13)$$

(III) $\quad P_0=1,\ P_1=P_{-1}=0$

$$I(\theta_1,\theta_2) = a_0^2 \qquad (14)$$

(IV) $\quad P_0=P_1=0,\ P_{-1}=1$ or $P_0=P_{-1}=0,\ P_1=1$

$$I(\theta_1,\theta_2) = a_1^2 \qquad (15)$$

The case of (1) described above (equation (12)) is a case where all of the 0-th order and ±1th order light beams are fetched and imaging is carried out by three-beam interference. The case of (II) described above (equation (13)) is a case where one of the 0-th order and ±1-th order light beams is fetched and the imaging is carried out by two-beam interference. The case of (III) described above (the above-described equation (14)) is a case where only the 0-th order light beam is fetched and occurs under the resolution limit, that is, when the space frequency is high. The case of (IV) described above (the above-described equation (15)) is a case where one of the ±1-th order light beams is fetched and occurs when the light source is extremely large.

(6) By substituting each of the above-described equations (12) to (15) into the above-described equation (4), the overall distribution of intensity I ($\alpha$, $\beta$) is found. However, the analysis of the above-described equations (12) to (15) suggests how it is possible to use the halftone phase shifting mask method with respect to a design pattern having any pattern density. Namely, when differentiating equation (12), there is a solution with which the cosine term and sine term become 0. This means that where imaging is carried out by three-beam interference, the secondary peak is always generated. Also, even if the above-described equation (13) is differentiated, only a solution with which the sine term becomes 0 exists. This suggests that the secondary peak will not be generated when the imaging is carried out by two-beam interference. Namely, it suggests that, when a light source giving a strong intensity of the light at the center portion of the fly's-eye lens is used as in the usual stepper, the three-beam interference becomes dominant and a secondary peak is generated, while when a light source giving a strong intensity of the light at the peripheral portion of the fly's-eye lens is used as in so-called oblique incident illumination, it becomes two-beam interference and a secondary peak is not generated.

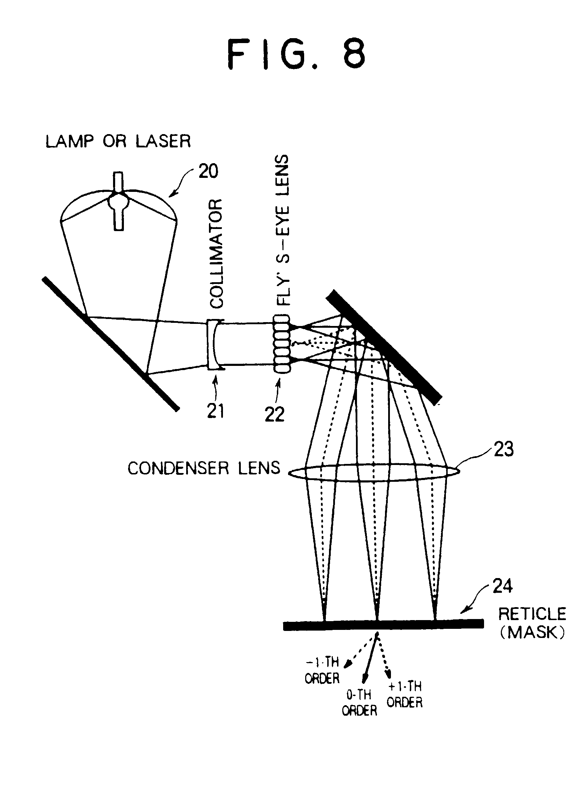

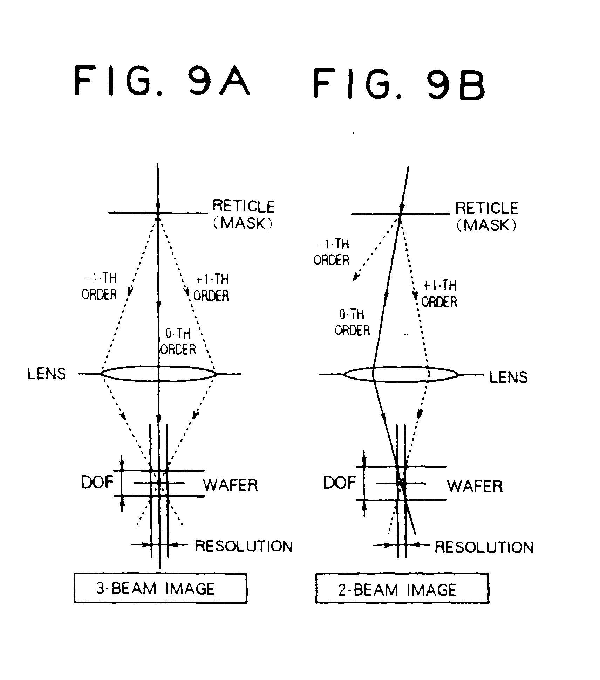

(7) With the oblique incident illumination technique, the illumination light is illuminated on the mask surface in an oblique direction, and as a result, either of the 0-th order light beam or +1-th orderlight beam is made incident upon the pupil surface as shown in Fig. 8 and Fig. 9B, the other primary light is rejected by the lens barrel, etc., and the pattern is formed by the two-beam interference. As a result, the apparent numerical aperture of the lens can be reduced and there is a great effect of improvement of the depth of focus. On the other hand, however, there are problems such as an increase of the adjacency effect due to the reduction of the effective light source, a lowering of the illuminance, an increase of the unevenness of illuminance, a lowering of the exposure margin, a strong influence of the telecentricity, etc.

Note that, in Fig. 8, reference numeral 20 denotes a lamp or a laser; reference numeral 21 denotes a collimator; reference numeral 22 denotes a fly's-eye lens; reference numeral 23 denotes a condenser lens; and reference numeral 24 denotes a reticle (mask). Also, Fig. 9A shows the case of three-beam interference; and Fig. 9B shows the case of two-beam interference.

(8) When considering the situation of the above-described (6) and (7), it is understood that it is desirable to have a distribution of the intensity of the light on the fly's-eye lens that emphasizes the oblique incident component to such an extent that a secondary peak, which is a problem in the halftone phase shifting mask, is not generated and has a vertical incident component such that the problem possessed by the oblique incident exposure method is not generated.

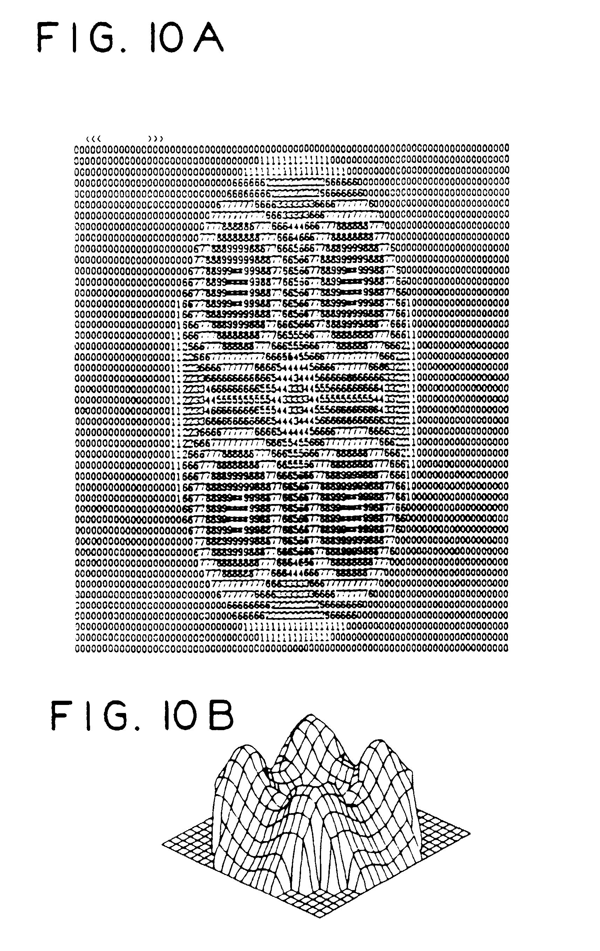

(9) Based on the above-described concept, the inventor discovered that the format shown in Figs. 10A and 10B is suitable as the distribution of the amount of light on the fly's-eye surface considering, in patterns of all directions, the depth of focus of the periodic pattern, the depth of focus of the isolated pattern, the generation of the secondary peak, the degree of the adjacency effect, the illuminance, the unevenness of illuminance, the distortion change, etc., and thereby completed the present invention. Figure 10A shows the distribution of the amount of light of the light incident upon the fly's-eye lens by numerals. The asterisk parts indicate the peak parts of the amount of light and the numerals 0 to 9 show the proportions of the amount of light where the peak part is defined as 10. A distribution of the amount of light is exhibited which is low in the center portion and high in the peripheral portions. Also, Fig. 10B shows three-dimensionally the distribution of the amount of light shown in Fig. 10A.

(10) The present invention can be preferably used in a case where the mask pattern of the semiconductor device is transferred to a resist by using photolithography and in other cases.

Concretely, the invention concerns a method of pattern formation according to claim 1.

The present invention is particularly effective because of the use of a phase shifting mask. The phase shifting mask is not particularly limited and may for example be a rim type or outrigger type phase shifting mask.

The region of the center portion of the aforesaid effective light source where the amount of light is lowered is for example a region of 10 to 40 percent of the outer diameter of the effective light source.

The peak of the amount of light at the peripheral portions of the aforesaid effective light source appears for example at a few points at rotationally symmetrical positions at the peripheral portions of the effective light source.

The amount of light incident upon the center portion of the aforesaid effective light source can be lowered in relation to the peak value of the amount of light incident upon the peripheral portions of the effective light source by using a beam splitter and a pyramid or conical prism lens. Further, the amount of the light incident upon the center portion of the effective light source can also be lowered with respect to the peak value of the amount of light incident at the peripheral portions of the effective light source by using a beam splitter alone, or pyramid or conical prism alone, or a plurality of pyramid or conical prisms.

It is also possible to lower the amount of light incident upon the center portion of the aforesaid effective light source lens relative to the peak value of the amount of light incident upon the peripheral portions of the effective light source by using a filter having a high transmittance at the peripheral portions as against the center portion.

It is also possible to lower the amount of light emitted from the center portion of the aforesaid fly's eye lens relative to the peak value of the amount of light emitted from the peripheral portions of the fly's eye lens by using a mechanical filter having opening portions corresponding to the individual lenses of the fly's-eye lens and having diameters of the related opening portions larger at the peripheral portions relative to the center portion.

It is also possible to lower the amount of light incident upon the center portion of the aforesaid effective light source relative to the peak value of the amount of light incident upon the peripheral portions of the effective light source by using a prism and optical parts arranged so that they can be made to approach or move away from this prism in the light path axis direction.

It is also possible to lower the amount of light emitted from the center portion of the aforesaid effective light source relative to the peak value of the amount of light emitted from the peripheral portions of the effective light source by dividing the beam incident upon the aforesaid effective light source to two or more beams, irradiating the two or more divided beams onto the aforesaid effective light source by using a movable mirror, and utilizing the difference in scanning speed at respective points of the surface of the effective light source dependent upon the surface shape of the aforesaid movable mirror.

The diameters of the individual lenses of the fly's eye lens may be uniform or may be larger at the center portion than the peripheral portions. For example, in a fly's eye lens, the diameters of the individual lenses at the center portion may be made 1.1 to 3 times the diameters of the individual lenses at the peripheral portions. By configuring the lens in this way, it is possible to prevent unevenness of illumination.

Further, in the present invention, when a single exposure time is T, it is possible to pass the light through a first filter with a higher transmittance at the peripheral portions than the center portion for a time of 0.05 x T to 0.95 x T and to pass it through a second filter or not pass it through a filter in the remaining exposure time. By this, it is possible to lower the amount of light from the center portion of the effective light source relative to the peak value of the amount of light emitted from the peripheral portions of the effective light source in just a single exposure time.

The invention further concerns an apparatus according to claim 15.

The diameters of the individual lenses of the fly's eye lens are preferably larger at the center portion than the peripheral portions.

The region of the center portion of the aforesaid effective light source where the amount of light is lowered by the light intensity distribution correcting means is preferably a region of 10 to 40 percent of the outer diameter of the effective light source.

The peak of the amount of light at the peripheral portions of the aforesaid effective light source preferably appears at a few points at rotationally symmetrical positions at the peripheral portions of the effective light source.

The light intensity distribution correcting means preferably has an optical element which lowers the amount of light incident upon the center portion of the effective light source in relation to the peak value of the amount of light incident upon the peripheral portions of the effective light source. In a fly's eye lens, the diameters of the individual lenses at the center portion are preferably 1.1 to 3 times the diameters of the individual lenses at the peripheral portions.

The optical element is preferably a beam splitter and/or a prism lens.

The light intensity distribution correcting means preferably has a filter having a high transmittance at the peripheral portions as against the center portion.

The light intensity distribution correcting means preferably has a mechanical filter, which mechanical filter has opening portions corresponding to the individual lenses of the fly's-eye lens and has diameters of the related opening portions larger at the peripheral portions relative to the center portion.

The light intensity distribution correcting means preferably has an optical element and optical parts arranged so that they can be made to approach or move away from this optical element in the light path axis direction. In this case, a prism etc. may be used as the optical element.

The light intensity distribution correcting means preferably further has means for dividing the beam incident upon the aforesaid effective light source to two or more beams, a movable mirror for irradiating the two or more divided beams onto the aforesaid effective light source, and scan means for lowering the amount of light emitted from the center portion of the aforesaid effective light source relative to the peak value of the amount of light emitted from the peripheral portions of the effective light source by using the difference in scanning speed at respective points of the surface of the effective light source dependent upon the surface shape of the aforesaid movable mirror.

The light intensity distribution correcting means may also have a first filter with a higher transmittance at the peripheral portions than the center portion and a switching means for switching between a state passing light through the first filter for a single exposure time and a state performing exposure without passing through the first filter. In this case, the apparatus of the present invention preferably further has a second filter with a distribution of transmittance different from the first filter and causes the light to pass through the second filter in the state performing exposure without passing through the first filter.

The switching means preferably has a rotary disk on which at least the first filter is mounted and a drive means for driving the rotation of the rotary disk. Further, the switching means may have a slide mechanism enabling at least the first filter to move slidably. Further, as the switching means, use may be made of an optical shutter type optical material whose transmittance of light changes according to the voltage applied.

The invention further concerns a method of production of a semiconductor device according to claim 32 and is particularly suitable for use when making a semiconductor device on a semiconductor substrate using the above mentioned method of pattern formation.

BRIEF DESCRIPTION OF THE DRAWINGS

These and other objects and features of the present invention will become clearer from the following description of the preferred embodiments made with reference to the attached drawings, in which

Fig. 1 is a view showing the fact that unevenness is always present on a substrate surface in an actual device;

Fig. 2A is a graph showing the dependency on the numerical aperture when the resolution of a depth of focus in a KrF excimer laser lithography is used as a parameter and Fig. 2B is a table thereof;

Fig. 3 is a a cross-sectional view of a phase shifting mask used in a halftone type phase shift method;

Fig. 4A is a graph showing the distribution of the intensity of the light on a wafer surface according to a chromium mask method and Fig. 4B is a graph showing the distribution of the intensity of the light on the wafer surface according to the halftone phase shift method;

Fig. 5A is a graph showing the existence of a secondary peak according to the halftone type phase shift method and Fig. 5B is a cross-sectional view showing that the peripheral portions are "gouged" in shape due to the secondary peak even in an isolated contact hole;

Fig. 6 is a conceptual view of a projection optical system of a stepper;

Fig. 7 is a view showing the positional relationship of rejection of diffractedlight;

Fig. 8 is a view showing the concept of an oblique incident illumination technique;

Fig. 9A shows a case of three-beam interference and

Fig. 9B is a conceptual view showing the case of two-beam interference;

Fig.10A is a view showing the distribution of the amount of light on a fly's-eye lens according to the present invention by numerical values and Fig.10B is a view showing three-dimensionally the distribution of the amount of light on the fly's-eye lens according to the present invention;

Fig. 11 is a view showing an example of an illumination optical system of a KrF excimer laser stepper;

Fig. 12A is a view showing the state of the beam on a prism, Fig. 12B is a view showing a superposition of beams on the fly's-eye lens; and Fig. 12C is a view showing the Gaussian distribution of the amount of light;

Fig. 13A is a view showing the distribution of the intensity of the light in a high density pattern where a reticle composed of a usual chromium mask is used and in addition the distribution of the amount of light on the fly's-eye lens is a Gaussian distribution and Fig. 13B is a view showing the distribution of the intensity of the light in the high density pattern where a reticle composed of a usual chromium mask is used and in addition the distribution of the amount of light on the fly's-eye lens is the distribution shown in Figs. 10A and 10B;

Fig. 14A is a view showing a distribution of the intensity of the light in a high density pattern where a reticle composed of a phase shift halftone mask is used and in addition the distribution of the amount of light on the fly's-eye lens is a Gaussian distribution and Fig. 14B is a view showing the distribution of the intensity of the light in the high density pattern where a reticle composed of a phase shift halftone mask is used and in addition the distribution of the amount of light on the fly's-eye lens is the distribution shown in Figs. 10A and 10B;

Figs. 15A and 15B are views showing a method of superposition of beams, in which Fig. 15A shows the state before the superposition and Fig. 15B shows the state after the superposition;

Fig. 16 is graph showing results of measurement of the distribution of the intensity of the light on a wafer surface for Comparative Example 1;

Fig. 17 is a graph showing results of measurement of the distribution of the intensity of the light on the wafer surface for Example A;

Fig. 18 is a graph showing results of measurement of the distribution of the intensity of the light on the wafer surface for Example B;

Fig. 19 is a graph showing results of measurement of the distribution of the intensity of the light on the wafer surface for Example C;

Fig. 20A is a cross-sectional view of a pattern formed where a halftone phase shifting mask is used in a usual illumination state of Comparative Example 1 and Fig. 20B is a cross-sectional view of a pattern formed where the exposure method according to Example C is used;

Fig. 21A is a plan view of a contact hole pattern formed where a halftone phase shifting mask is used in a usual illumination state of Comparative Example 1 and Fig. 21B is a cross-sectional view of a contact hole pattern formed where the exposure method according to Example C is used;

Figs. 22A and 22B show the effective improvement of the depth of focus with a line width of 0.30 $\mu$m, in which Fig. 22A is a graph showing a depth of focus when the distribution of the intensity of the light on the conventional (Comparative Example 1) fly's-eye lens is used without use of the halftone phase shifting mask and Fig. 22B is a graph showing the depth of focus when the exposure method according to Example C is used;

Fig. 23 is a plan view of the fly's-eye lens;

Fig. 24 is a view showing the concept of a mechanical filter for use in the present invention;

Fig. 25 is a view showing the state of a beam when a pyramid prism or conical prism is used according to the present invention;

Fig. 26 is a schematic view of a pattern for explaining Example 8.

Figs.27A to 27C are graphs showing the variations in critical dimensions achieved according to Example 8 and Comparative Examples 4 and 5;

Figs. 28A to 28C are SEM photographs of hole patterns achieved according to Example 9 and Comparative Examples 6 and 7;

Fig. 29 is a view of the distribution of the intensity of the light used in Example 10;

Figs. 30A and 30B are views of examples of filters used in Examples 10 and 11;

Fig. 31 is a view showing the concept of addition of distributions of the Intensity of the light used in Example 10;

Figs. 32A to 32C are views of examples of switching devices of filters useable in the present invention;

Fig. 33 is a view showing the concept of addition of distributions of the intensity of the light used in Example 11;

Figs. 34A to 34C are SEM photographs of hole patterns of Example 13 and Comparative Examples 8 and 9; and

Fig. 35 is a view of the depth of focus in the Example 13 and Comparative Examples 8 and 9.

## DESCRIPTION OF THE PREFERRED EMBODIMENTS

Below, embodiments of the present invention will be concretely explained. Note, of course, the present invention is not restricted by the embodiments.

### Example 1

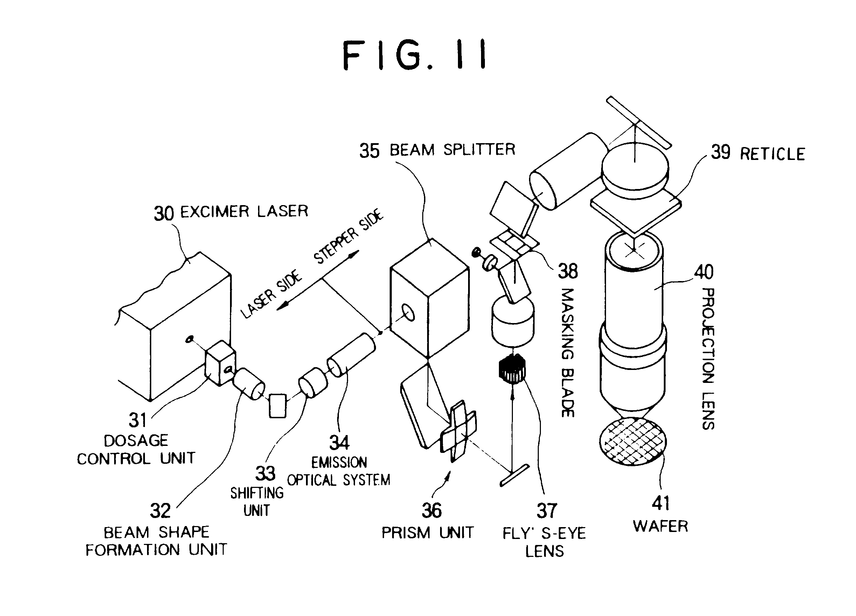

This example is one wherein the distribution of the amount of light shown in Figs. 10A and 10B is formed on an incident plane of the fly's-eye lens 37 of an exposure device shown in Fig. 11 and the depth of focus is improved so as to stably transfer a semiconductor device pattern using a halftone phase shifting mask. Note that Figs. 10A and 10B show a shape wherein a quadrupole is formed, though slight, but there is no problem even if a annular or other shape is adopted. The results shown in the present example are results obtained by using a KrF excimer laser stepper, but the results have generality and are not results which cannot be obtained depending on the wavelength used. They can be applied as they are to conventionally used g-rays and i-rays as well. Also, they can be preferably used also with respect to future ArF excimer lasers and other wavelengths.

First, an explanation will be made of the overall structure of the exposure device.

As shown in Fig. 11, this exposure device comprises a laser device and a stepper device. The laser device is constituted by an excimer laser 30, a dosage control unit 31, a beam shape formation unit 32, a shifting unit 33, and an emission optical system 34.

The stepper device is constituted by a beam splitter 35, a prism unit 36, a fly's-eye lens 37, a masking blade 38, a reticle 39, and a projection lens 40. The light for exposure emitted from the excimer laser 30 is made incident upon the fly's-eye lens 37 through the aforesaid various optical systems. The fly's-eye lens 37 becomes the secondary light source. That light for exposure reaches the top of the surface of the wafer 41 through the reticle 39 on which the mask pattern is formed. The pattern of the reticle 39 is transferred onto the wafer surface.

The fly's-eye lens 37 is an assembly of a plurality of (for example, 100) lenses. The outer diameter as a whole is usually 5 cm to 20 cm.

Next, an explanation will be made of the procedure when the distribution of the amount of light shown in Figs. 10A and 10B is selected for the incident plane to the aforesaid fly's-eye lens 37. The procedures of the following (1) to (3) were carried out.

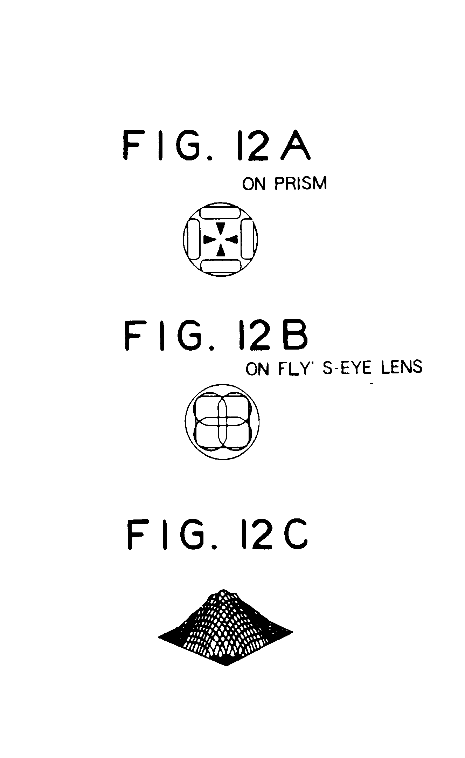

(1) The distribution of the amount of light on the surface of the fly's-eye lens of a conventional stepper becomes a Gaussian distribution of a high amount at the center portion and a low amount at the peripheral portions as shown in Fig. 12C. This is because, as shown in Fig. 12A, the light split by the beam splitter 35 is combined by the prism as shown in Fig. 12B.

Since the distribution of the amount of light becomes that shown in Fig. 12C, there was a problem that the illumination light effective for a rough pattern was strong and, simultaneously, the illumination light generating a secondary peak on the wafer 41 surface and effective for a fine pattern was weak.

(2) So as to solve this problem, the intensity of the light of the center portion of the fly's-eye lens was gradually shielded, and the oblique incident component was emphasized to an extent that the secondary peak, which is the problem in a halftone phase shifting mask, was not generated.

(3) As a result, it was found that, when the maximum intensity of the light existing at the peripheral portions on the fly's-eye lens was defined as 1, in a distribution of intensity wherein the intensity of the center portion was 0.9 or less, preferably 0.8 or less, a secondary peak was not generated.

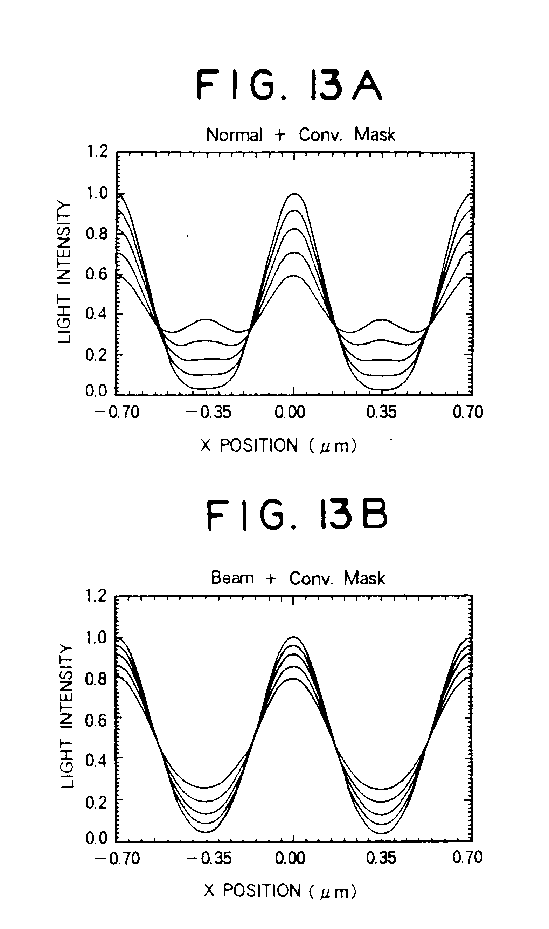

Figure 13A shows the distribution of the intensity of the light in a high density pattern in a case where a reticle comprising a usual chromium mask was used and in addition the distribution of the amount of light on the fly's-eye lens was a Gaussian distribution. Figure 13B shows the distribution of the intensity of the light in a high density pattern in a case where the reticle comprising a usual chromium mask is used and in addition the distribution of the amount of light on the fly's-eye lens is the distribution shown in Figs. 10A and 10B.

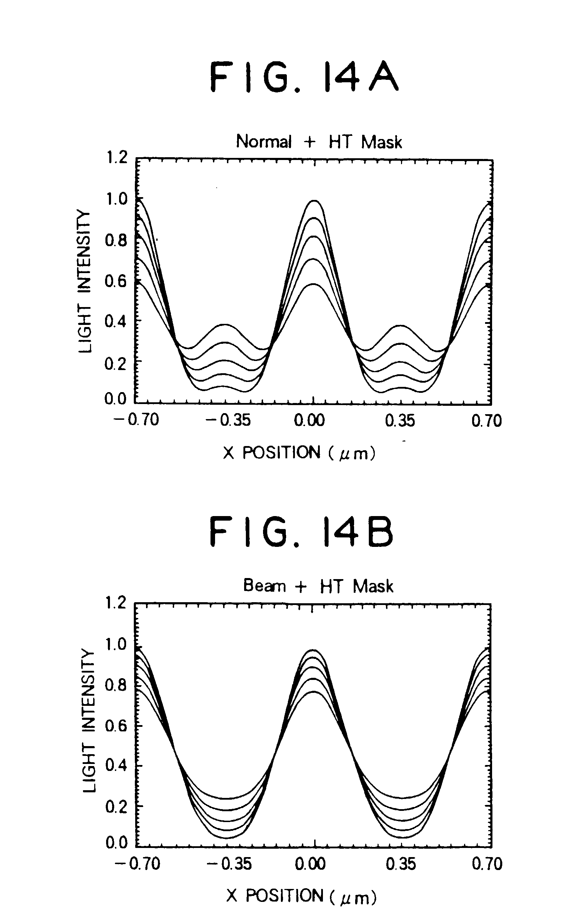

Figure 14A shows the distribution of the intensity of the light in a high density pattern in a case where a reticle comprising a phase shift halftone mask was used and in addition the distribution of the amount of light on the fly's-eye lens was a Gaussian distribution. Figure 14B shows the distribution of the intensity of the light in a high density pattern in a case where the reticle comprising a phase shift halftone mask was used and in addition the distribution of the amount of light on the fly's-eye lens was the distribution shown in Figs. 10A and 10B.

In Figs. 13A and 13B and 14A and 14B, the conditions were a wavelength $\lambda$ for the exposure light of 248 nm, a numerical aperture NA of 0.45, a $\sigma$ of 0.7, a ratio of the line width versus the interval of 1:1, and a resolution of 0.35 $\mu$m. The focus F was changed to 0.0, 0.4, 0.6, 0.8, and 1.0 $\mu$m.

As shown in Fig. 13B and Fig. 14B, when the method of the present invention is used, the secondary peak is reduced.

The results shown in Figs. 10A and 10B show the formation of a quadrupole, though slight, but there is no problem even if an annular or other shape is adopted. In the end, it is sufficient so far as the intensity of the center portion is 0.9 or less, preferably 0.8 or less when the maximum intensity of the light existing at the peripheral portions on the fly's-eye lens is defined as 1.

(4) An exposure technique for enlarging the depth of focus, without being influenced by the secondary peak, by using a halftone phase shifting mask and without a placing a load on the design of the mask was established by using the present example.

Example 2

The present example is one wherein a desired distribution of the intensity of the light on the fly's-eye lens in the present invention is formed when stably transferring a semiconductor device pattern by using KrF excimer lithography using the halftone phase shifting mask. The procedures of the following (1) to (3) were carried out.

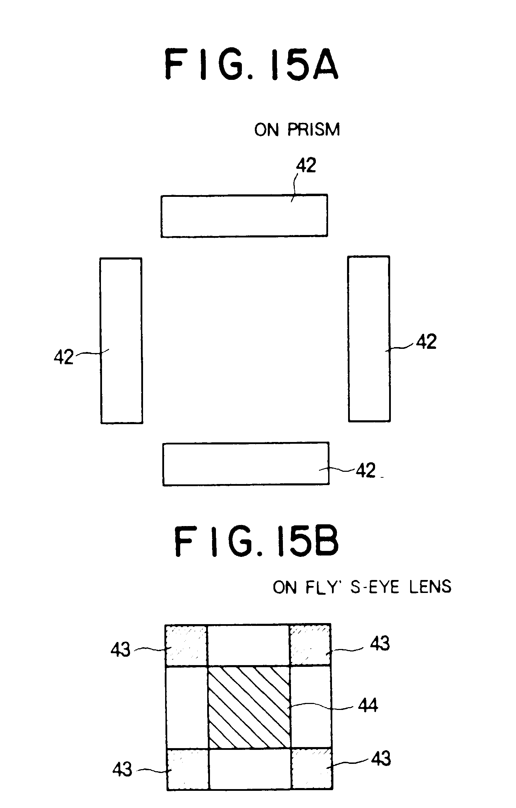

(1) In the illumination optical system of the KrF excimer laser stepper shown in Fig. 11, the laser beam was divided into four beams by the beam splitter. Therefore, a desired distribution of the amount of light was reproduced on the fly's-eye lens by adjusting the opening angle of the beams and beam intervals when resuperposing these divided beams.
(2) Namely, by dividing a beam 42 as shown in Fig. 15A by the beam splitter 35 shown in Fig. 11 and superposing the resultant beams by using a prism unit 36 shown in Fig. 11 (refer to Fig. 15B), the desired distribution of the amount of light of the present example was reproduced on the fly's-eye lens.
In Fig. 15A, the shape of the light source after the superposition determined how much the respective beams 42 before the superposition were shifted to the inside or how much the dimensions were to be made at the shorter side direction of the beams. In Fig. 15B, the four corner portions 43 are light superposition portions and parts acting as the peak parts of the amount of light. At the center portion 44, light exists due to the spread of the respective beams, but the amount of light is low.
The distribution of the amount of light on the fly's-eye lens surface obtained when the beams are superposed by using the present method is similar to the results shown in Figs. 10A and 10B.
(3) From the above, in the example of the present invention, a shape of a light source emphasizing the oblique incident component to such an extent that the secondary peak was not generated was established.

Example 3

In the above-described Example 2, when forming a shape of the light source shape emphasizing the oblique incident component to such an extent that the secondary peak is not generated, if the intensity of the light at the center portion on the fly's-eye lens is set too small, the problem inherent in the oblique incident exposure method mentioned above becomes more conspicuous, although a secondary peak is not generated. The present example is one wherein the lower limit (2 percent) of the intensity of the light of the center portion on the fly's-eye lens is found based on the following optimization:

(1) The influence exerted upon the resolution performance when changing the intensity of the light at the center portion of the fly's-eye lens is shown in Table 1.

Table 1

| | | Comp. Ex. 1 | Ex. A | Ex. B | Ex. C | Ex. D | Comp. Ex 2 | Comp. Ex. 3 |
|---|---|---|---|---|---|---|---|---|
| 0.35 μm DOF (μm) | Center of vertical line | 1.4 | 1.8 | 1.8 | 2.1 | 2.6 | 3.5 | 2.0 |
| | End portion of vertical line | 1.3 | 1.8 | 2.0 | 1.8 | 2.2 | 3.5 | 2.0 |
| | Center of oblique line | 1.6 | 2.0 | 2.1 | 2.1 | 2.4 | 1.8 | 3.3 |
| | End portion of oblique line | 1.5 | 1.6 | 1.5 | 1.7 | 2.2 | 1.7 | 1.8 |
| | Vertical isolated line | 1.3 | 1.3 | 1.5 | 1.4 | 1.5 | 1.4 | 1.3 |
| | Oblique isolated line | 1.4 | 1.3 | 1.3 | 1.4 | 1.4 | 1.0 | 1.2 |
| | Overall | 0.42 | 0.6 | 1.0 | 1.1 | 0.8 | 1.02 | 1.2 |
| CD uniformity (μm) | | 0.062 | 0.065 | 0.060 | 0.050 | 0.070 | 0.062 | 0.042 |
| Illumination output (mw/cm$^2$) llumination | | 220 | 220 | 210 | 200 | 194 | 62 | 64 |
| uniformity (%) | | 1.4 | 1.5 | 1.3 | 1.5 | 2.0 | 6.6 | 5.7 |
| Light amount of center portion (%) | | – | 90% | 50% | 30% | 2% | – | – |

Gauss distribution

Four-point illumination

Annular illumination

EP 0 698 824 B1

Table 1 shows the change of the depth of focus, line width uniformity, illuminance, illuminance unevenness, and distortion with a line width of 0.35 µm.

In the table, the part indicated by "overall" is the common depth of focus for all these groups. Namely, the values of the depth of focus indicated for "overall" are the depths of focus important when fabricating an actual semiconductor device in which various pattern shapes, roughness or density of pattern, and directivity are contained.

Also, Comparative Example 1 shows a conventional exposure method giving a distribution of the intensity of the light of a Gaussian distribution on the fly's-eye lens surface; Comparative Example 2 shows four-point illumination in the oblique incident illumination; and Comparative Example 3 shows annular illumination.

Examples A, B, C, and D show depths of focus when using distributions of the intensity of the light having a vertical incident component so that the oblique incident component is gradually emphasized in the intensity of the light of the center portion of the fly's-eye lens and the problem possessed by the oblique incident exposure method is not generated. In these Examples A, B, C, and D, the conditions are the same except that the amount of light of the center portion on the incident plane of the fly's-eye lens is changed to 90 percent, 50 percent, 30 percent, and 2 percent, respectively, with respect to the peak value of the peripheral portions.

The overall depth of focus is 0.42 µm in the conventional exposure method (Comparative Example 1), while the depth of focus is 1.02 µm in the oblique incident illumination (Comparative Example 2) and 1.2 µm in the annular illumination (Comparative Example 3). Namely, where the oblique incident illumination and annular illumination are used, there is a conspicuous effect of improvement of the depth of focus at the center portion of a five-bar chart, but the depth of focus containing all patterns due to the already mentioned problem, that is, the adjacency effect, is not so great.

On the other hand, in the intensity of the light at the center portion on the fly's-eye lens, when the oblique incident component is gradually emphasized and a distribution of the intensity of the light having a vertical incident component is used so that the problem possessed by the oblique incident exposure method is not generated (Examples A to D), even in the effect of improvement of the depth of focus at the center line of the five-bar chart, an effect of improvement of the depth of focus equivalent to that by annular illumination (Comparative Example 3) is obtained, i.e., the depth of focus is improved 2.5 times or more compared with the conventional method (Comparative Example 1).

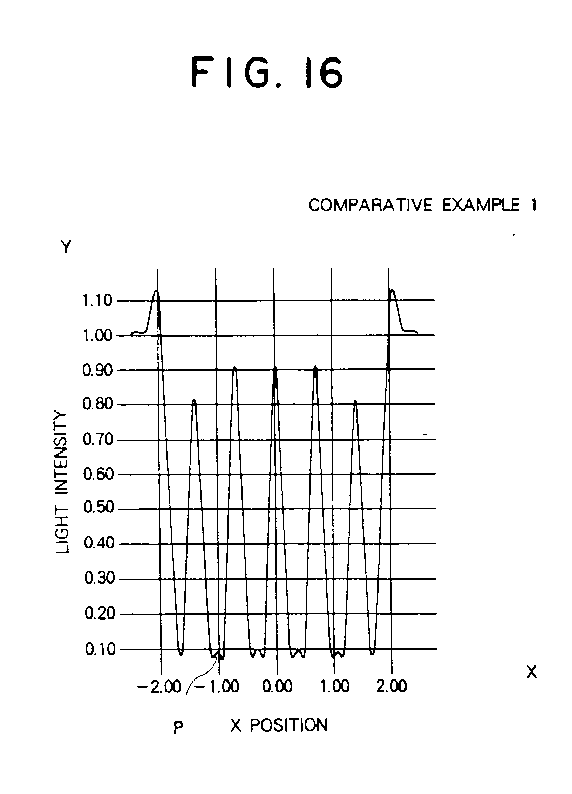

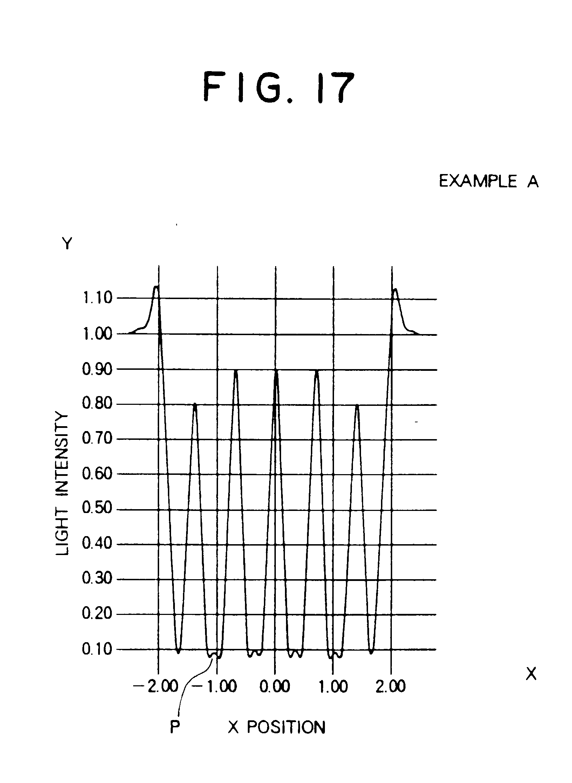

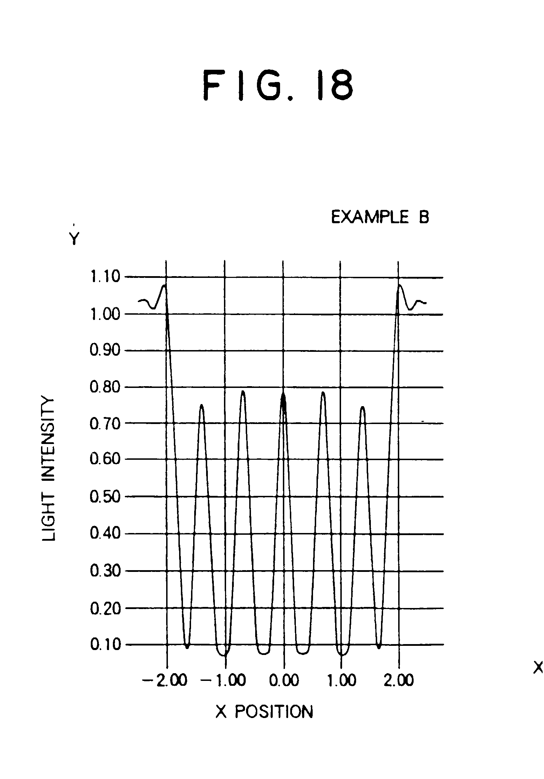

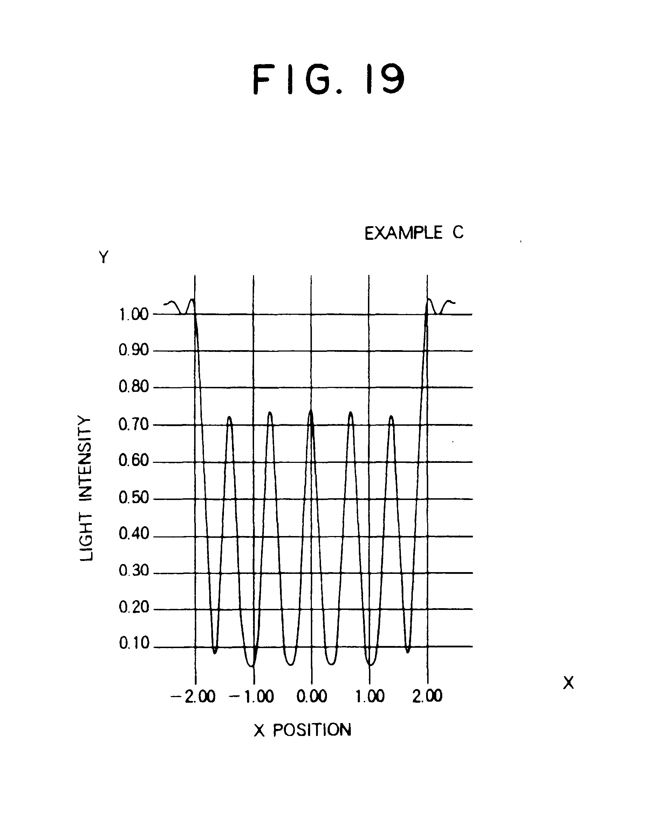

The results of measurement of the distribution of the intensity of the light on the wafer surface for the aforesaid Examples A, B, and C are shown in Figs. 17 to 19, while those for the conventional method (Comparative Example 1) are shown in Fig. 16. As shown in Figs. 17 to 19, in comparison with the conventional method shown in Fig. 16, in the present Examples A, B, and C, the secondary peak p could be reduced.

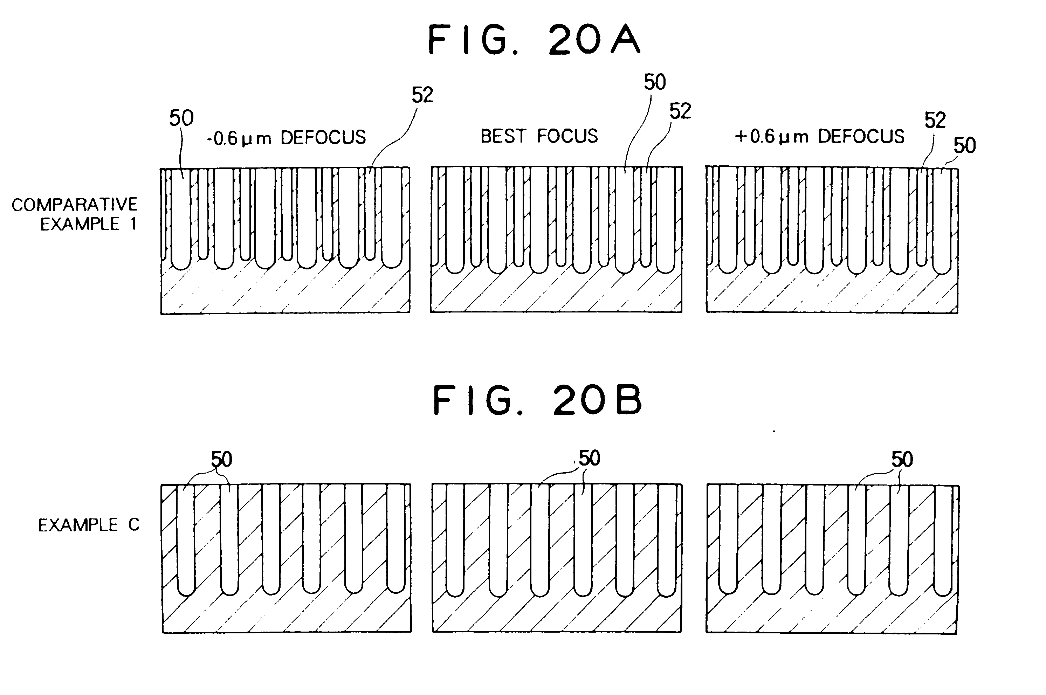

In actuality, in the above-described Comparative Example 1 and Example C, the difference of the resolution performances where the pattern is formed on the surface of the semiconductor wafer is shown in Figs. 20A and 20B. Figure 20A is a cross-sectional view of a wafer where a line pattern having a line width of 0.30 µm is actually formed by using the halftone phase shifting mask in a usual illumination state of Comparative Example 1. The used exposure device is a KrF excimer laser stepper of a numerical aperture of 0.45. As a resist, a chemical amplifying type positive resist was used. Attention was paid to a pattern having a rough/dense ratio of line versus space of 1:1.5.

Figure 20B is a cross-sectional view of a wafer in the case where light is illuminated onto the fly's-eye lens with a distribution of the amount of light of Example C, this is used as a secondary light source, and a line pattern having a line width of 0.30 µm is actually formed by using the halftone phase shifting mask. The other conditions are similar to the case of Fig. 20A.

In the conventional method (Comparative Example 1), the pattern 52 resulting from the secondary peak ends up resolved in addition to the desired pattern portion 50. On the other hand, in the exposure method according to the present Example C, the pattern 50 is preferably formed without influence by the secondary peak. Also, even if the focus is deviated by ±10.6 µm, a good pattern 50 is formed.

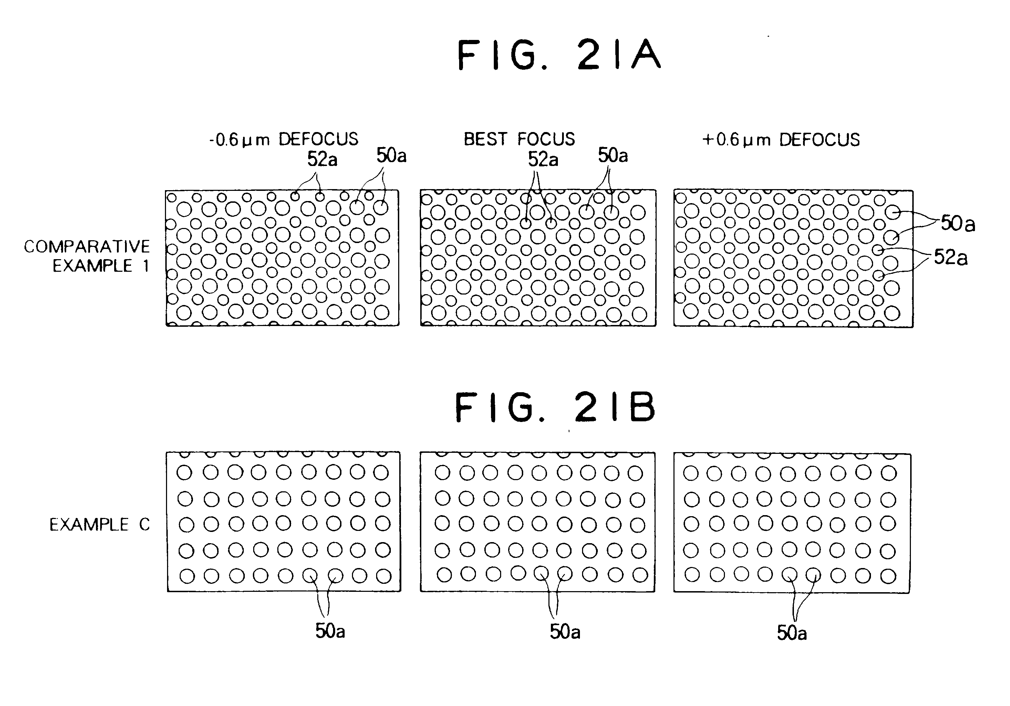

Figure 21A is a plan view of a semiconductor wafer where a contact hole of 0.3 µm is actually formed by using the halftone phase shifting mask in the usual illumination state of the above-described Comparative Example 1. The used exposure device is a KrF excimer laser stepper of a numerical aperture 0.45. As a resist, a chemical amplifying type positive resist was used. Attention was paid to a pattern having a rough/dense ratio of 1:1.

Figure 21B is a cross-sectional view of a wafer in the case where light is illuminated onto the fly's-eye lens with a distribution of the amount of light of Example C, this is used as a secondary light source, and a contact hole of 0.30 µm is actually formed by using a halftone phase shifting mask. The other conditions are similar to the case of Fig. 20A.

In the conventional method (Comparative Example 1), the pattern 52a resulting from the secondary peak ends up resolved in addition to the desired pattern portion 50a. On the other hand, in the exposure method according to the present Example C, the pattern 50a is advantageously formed without influence by the secondary peak.

Also, even if the focus is deviated by ±0.6 µm, a good pattern 50a is formed.

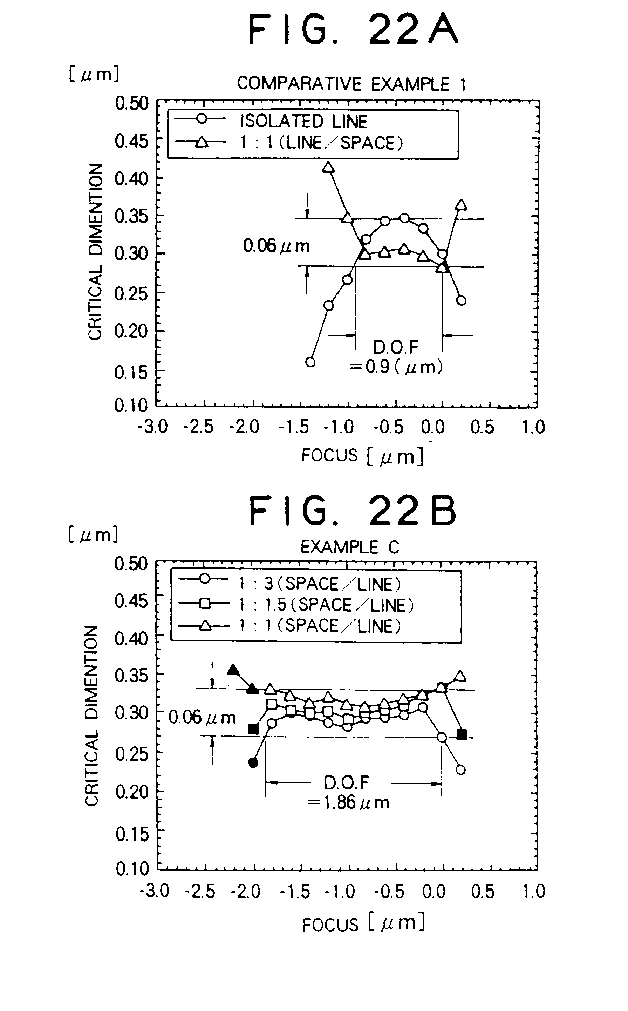

Figures 22A and 22B show the effect of improvement of the depth of focus with a line width of 0.30 µm. The used exposure device is a KrF excimer laser stepper of a numerical aperture of 0.45. As the resist, a chemical amplifying type positive resist was used. Attention was paid to patterns having a rough/dense ratio of line versus space of 1:1 and 3:1. When a halftone phase shifting mask was not used and the conventional (Comparative Example 1) distribution of the intensity of the light on the fly's-eye lens was used, a depth of focus of only about 0.9 µm could be obtained. On the other hand, in the exposure method according to the present example C, a depth of focus of 1.86 µm, which is more than two times this, is obtained. Note that, although it has been already mentioned, when the distribution of the intensity of the light on the conventional fly's-eye lens and the halftone phase shifting mask are combined, a pattern resulting from the secondary peak ends up resolved, and allowable imaging is not achieved.

According to the present example C, it was confirmed that the depth of focus could be enlarged without influence by the secondary peak and without a load being placed on the design of the mask by using a halftone phase shifting mask.

(2) As shown in Table 1, the illuminance (illumination output) is lowered to about 30 percent in comparison with the conventional method (Comparative Example 1) when using the oblique incident illumination (Comparative Example 2) method or annular illumination (Comparative Example 3) method. On the other hand, in the present Examples A to D, an illuminance (illumination output) lowered to about 10 percent is enough. Moreover, the unevenness of illumination (illumination uniformity) deteriorates to about 5 percent if the oblique incident method (Comparative Example 2) or the annular illumination method (Comparative Example 3) is used. Considering the sensitivity of the resist, the line width varies due to the unevenness of illumination. On the other hand, when the examples of the present invention are used, the unevenness of illumination is the same degree as with the conventional method, so there is no adverse influence by the present invention.

(3) When defining the intensity at the peripheral portions of the fly's-eye lens as 100, it was found that with a distribution of intensity giving an intensity of the center portion of 2 percent, preferably 20 percent or more, there were none of the problems possessed by the oblique incident exposure method, that is, the increase of the adjacency effect due to the reduction of the effective light source, lowering of the illuminance, increase of the illuminance unevenness, lowering of the exposure margin, a strong influence of the telecentricity, etc.

Namely, it is learned that a distribution of the intensity of the light on the fly's-eye lens having a vertical incident component of 2 percent, preferably about 20 percent or more, is preferable so as not to cause the problems possessed by the oblique incident exposure method.

(4) It was found from the above that, according to Example 1 and the present example, when the maximum intensity of the light in the distribution of the intensity of the light on the fly's-eye lens was 100, by setting the intensity of the light of the center portion to 2 to 90 percent, preferably 20 to 80 percent, no secondary peak was generated in the distribution of the intensity of the light on the wafer surface and there were none of the problems inherent in the oblique incident exposure method.

The results shown in the present example are results obtained by using a KrF excimer laser stepper, but the results have generality and can be applied as they are to conventionally used g-rays and i-rays as well. Also, they can be preferably used also with respect to future ArF excimer lasers and other wavelengths.

Example 4

The present example is one wherein the desired distribution of the intensity of the light on a fly's-eye lens in the present invention is formed by using an absorption type or reflection type filter mounted on the fly's-eye lens when stably transferring the semiconductor device pattern by using a halftone phase shifting mask.

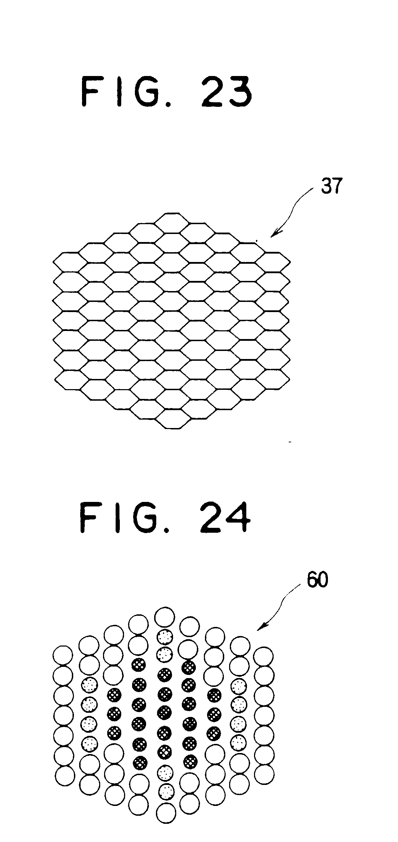

In the illumination optical system of the stepper, when defining the distribution of the intensity of the light immediately before the light is incident upon the fly's-eye lens 37 shown in Fig. 23 as $I_0$ (x, y), the desired distribution of the intensity of the light can be obtained by attaching an absorption or reflection type filter having a transmittance T (x, y) to the position immediately before or after the light is incident on the fly's-eye lens. Namely, a filter having a different transmittance for each position was obtained by vapor-depositing a semi-transparent film to the surface of a ground material such as of synthetic quartz. Note, the coordinate system on the fly's-eye lens surface is made (x, y).

Due to the above, a state of the light source which emphasizes an oblique incident component to such an extent that a secondary peak is not generated and does not have any of the problems inherent in the oblique incident exposure method was established.

Example 5

The present example is one wherein the desired distribution of the amount of light is formed on the fly's-eye lens surface by using a mechanical filter 60 as shown in Fig. 24 when stably transferring a semiconductor device pattern by using a halftone phase shifting mask.

In the distribution of the intensity of the light immediately before the light is incident upon the fly's-eye lens, in the case of a so-called "Gaussian distribution" illumination where the center portion has a strong intensity of the light, a metal plate provided with openings having a size the same extent as that of the individual fly's-eye lenses for the peripheral region in which the oblique incident component should be emphasized and having gradual smaller openings than that of the individual fly's-eye lenses toward the center region is inserted immediately before the fly's-eye lens so that the distribution of the intensity of the light immediately after the transmission through the fly's-eye lens becomes the desired distribution of the intensity of the light.

Note that, in the case of a so-called "flat" illumination where the distribution of the intensity of the light immediately before the light is incident upon the fly's-eye lens is flat, a metal plate provided with openings having a size the same extent to that of the individual fly's-eye lenses for the region in which the oblique incident component should be emphasized having smaller openings than that of individual fly's-eye lenses at the center portion where the intensity of the light should be lowered is inserted immediately before the fly's-eye lens so that the distribution of the intensity of the light immediately after the transmission through the fly's-eye lens becomes the desired distribution of the intensity of the light.

Due to the above, a state of the light source which emphasizes an oblique incident component to such an extent that a secondary peak is not generated and does not have any of the problems inherent in the oblique incident exposure method was established.

Example 6

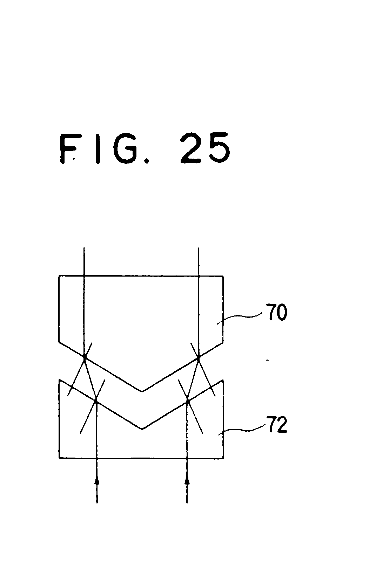

The present example is one wherein the desired distribution of the intensity of the light on the fly's-eye lens in the present invention is obtained by attaching a pyramid prism or a conical prism in the interior of the illumination system, which has not been divided in the light path, when stably transferring a semiconductor device pattern by using a halftone phase shifting mask. It is also possible to use these prisms alone or to use a prism 70 integral with anoptical part 72 having a shape fitting the same as shown in Fig. 25. Where used integrally, when the exposure method according to the present invention is used, the desired distribution of the intensity of the light on the fly's-eye lens is obtained by making the distance between the prism 70 and the optical part 72 having a shape fitting the same variable.

Moreover, in the formation of a pattern by using usual illumination as well, use may be made of a prism and an optical part 72 having a shape fitting the same attached closely together. Namely, a zoom function is given by either of the prism 70 or the optical part 2 having a shape fitting the same and the zoom function is controlled by input from the console side.

Due to the above, a state of the light source which emphasizes an oblique incident component to such an extent that a secondary peak is not generated and does not have any of the problems inherent in the oblique incident exposure method was established.

Example 7

The present example is one wherein, when stably transferring a semiconductor device pattern by using a halftone phase shifting mask, the light path is divided into two or more paths, the illumination light is irradiated onto the fly's-eye lens by using a vibration mirror having a concave surface or a rotating polygonal mirror in individual light paths, and use is made of the difference of the scanning speed at the surfaces of points of the fly's-eye lens depending upon the shape of the mirror surface so as to control the oblique incident component and vertical incident component through the entire exposure time and control the distribution of the diffracted light at the mask. Note, the scanning directions when using the two or more divided beams are made orthogonal. Note that the scanning speed was controlled by synchronizing the same with the resist exposure time.

Due to the above, a state of the light source which emphasizes an oblique incident component to such an extent that a secondary peak is not generated and does not have any of the problems inherent in the oblique incident exposure method was established.

Example 8

This example is one in which the intensity of the light at the center portion of the fly's-eye lens is made 30 percent relative to that of the peripheral portions as in Example C of the above Example 3 when transferring a memory cell pattern using a halftone phase shifting mask. The distribution of the intensity of the light is the same as the distribution shown in Figs. 10A and 10B. The exposure device used was the one shown in Fig. 11. More specifically, use was made of a KrF excimer laser stepper of a numerical aperture of 0.45. Further, as the resist, use was made of a chemically amplified positive resist (WKR-PT2).

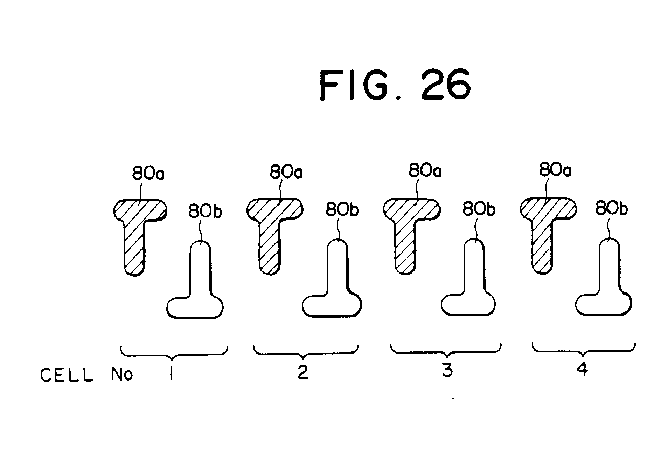

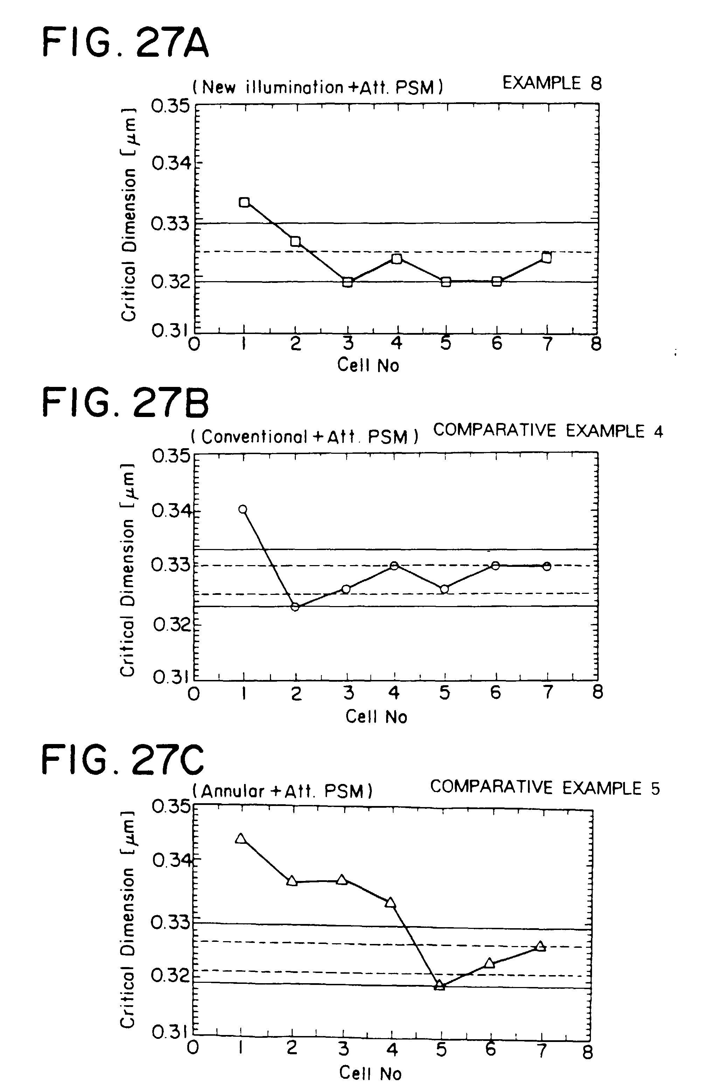

An outline of the memory cell pattern obtained by this exposure is shown in Fig. 26. One cell is constituted by a pair of gate electrodes 80a and 80b. Considering the fact that the memory cells are densely arranged no matter what the position on the wafer, cell numbers were given in order from the end and the critical dimensions of the pattern of one electrode in a cell, for example, the left side gate electrode 80a, were measured. The variations in the critical dimensions in Example 8 are shown in Fig. 27A.

As Comparative Example 4, the same procedure was performed as in Example 8, except that the distribution of the intensity of light irradiated on the fly's-eye lens was made the Gaussian distribution shown in Fig. 12C, to form a memory cell pattern. The results of measurement, performed in the same way as in Example 8, are shown in Fig. 27B.

As Comparative Example 5, the same procedure was performed as in Example 8, except that the distribution of the intensity of light irradiated on the fly's-eye lens was made an annular illumination distribution (the intensity of the light at the center portion of 0), to form a memory cell pattern. The results of measurement, performed in the same way as in Example 8, are shown in Fig. 27C.

In Example 8, it was confirmed that the variations in critical dimensions were greatly reduced compared with Comparative Example 5 of the annular illumination. Further, in Comparative Example 4, while there was little variation in the critical dimensions, the effective light source was a conventional Gaussian distribution one, so there was the chance of occurrence of a secondary peak and the depth of focus was small.

Example 9

This example is one in which the intensity of the light at the center portion of the fly's-eye lens is made 30 percent relative to that of the peripheral portions as in Example C of the above Example 3 when transferring a 0.30 μm inside diameter contact hole pattern using a halftone phase shifting mask. The distribution of the intensity of the light is the same as the distribution shown in Figs. 10A and 10B. The exposure device used was the one shown in Fig. 11. More specifically, use was made of a KrF excimer laser stepper of a numerical aperture of 0.45. Further, as the resist, use was made of a chemically amplified positive resist (WKR-PT2).

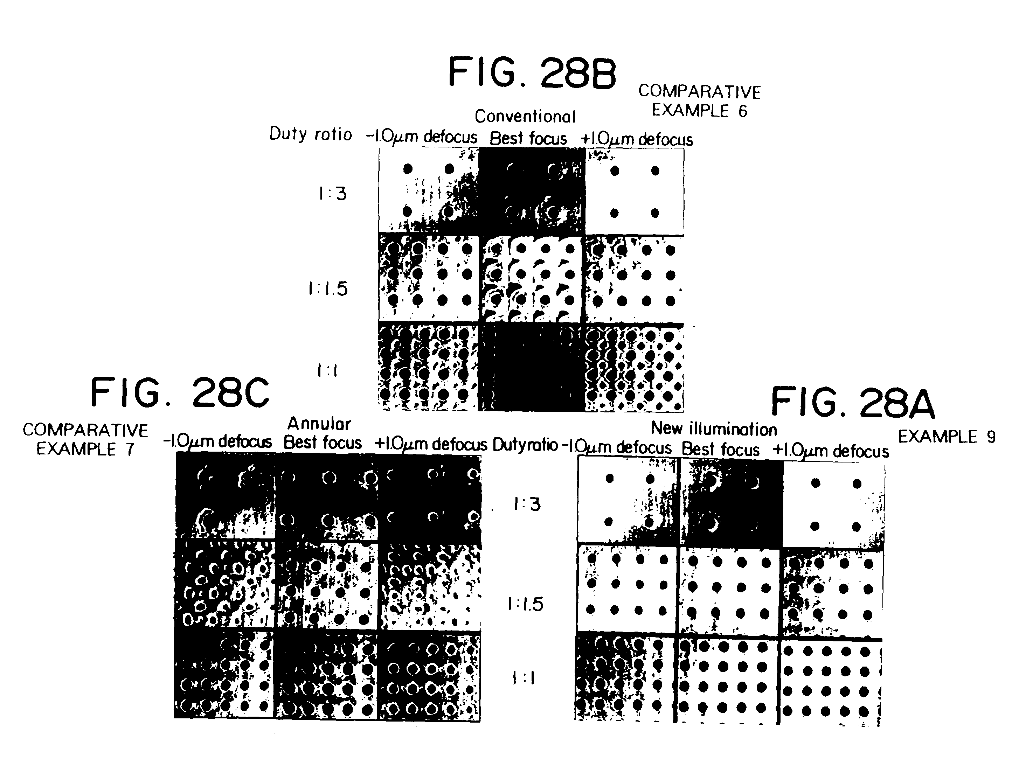

Patterns were formed under conditions of a best focus, a -1.0 μm defocus, and a +1.0 μm defocus for patterns of ratios of the inside diameter of the contact holes and the intervals between them (duty ratio) of 1:3, 1:1.5, and 1:1. That is, patterns were formed for nine sets of conditions. SEM photographs of the contact hole patterns obtained under these nine sets of exposure conditions are shown all together in Fig. 28A. As illustrated, it was confirmed that contact hole patterns can be excellently formed even if the duty ratios differ or with defocusing.

As Comparative Example 6, the same procedure was performed as in Example 9, except that the distribution of the intensity of light irradiated on the fly's-eye lens was made the Gaussian distribution shown in Fig. 12C, to form contact hole patterns. The results of observation by SEM photographs, performed in the same way as in Example 9, are shown in Fig. 28B. In patterns with densely arranged holes, holes caused by the secondary peak ended up being formed.

As Comparative Example 7, the same procedure was performed as in Example 9, except that the distribution of the intensity of light irradiated on the fly's-eye lens was made an annular illumination distribution (the intensity of the light at the center portion of 0), to form contact hole patterns. The results of observation by SEM photographs, performed in the same way as in Example 9, are shown in Fig. 28B. While there was no problem at the time of the best focus, good holes could not be formed at the time of defocusing.

Example 10

Example 10 is one in which the amount of the light emitted from the center portion of the effective light source is lowered by a certain amount relative to the amount of light emitted from the peripheral portions of the effective light source by passing light through a first filter with a higher transmittance at the peripheral portions as against the center portion for a time of 0.05 x T to 0.95 x T, when a single exposure time is T, and not passing it through the filter in the remaining exposure time.

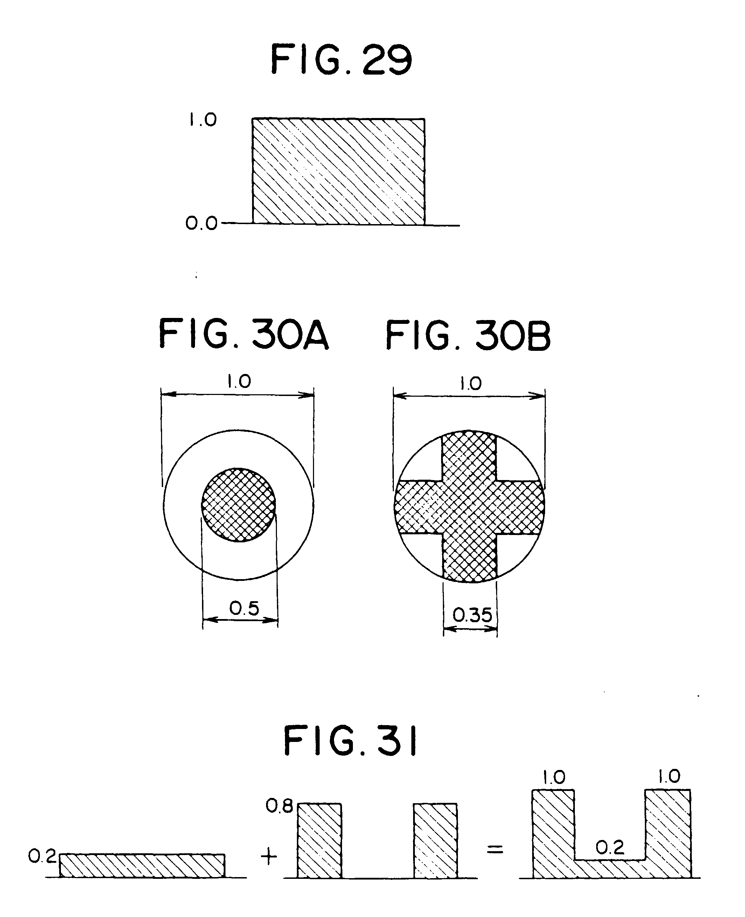

In this example, use is made of an exposure device of the basic configuration shown in Fig. 11. In the state where the light is not passed through the filter, the distribution of the intensity of the light incident on the fly's-eye lens used as the effective light source is made the flat distribution of intensity of light shown in Fig. 29.

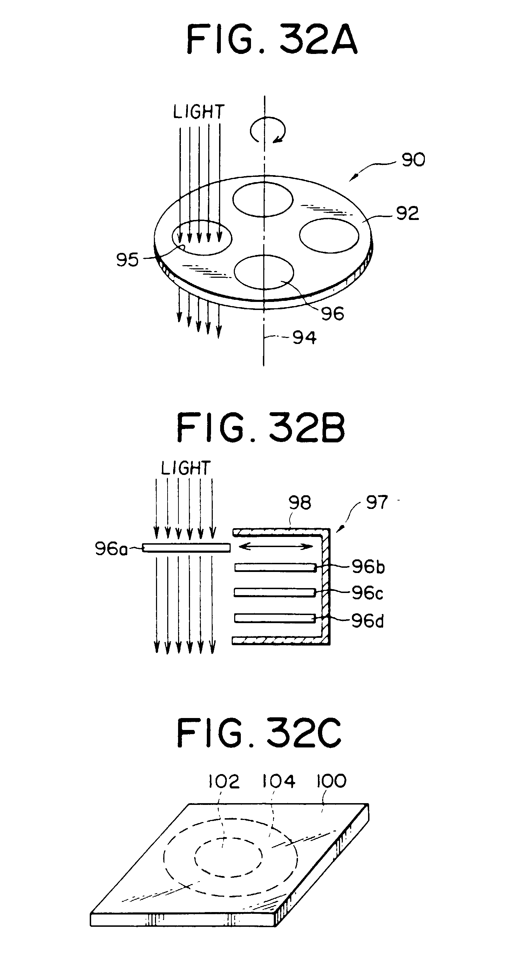

In this example, the rotary disk type filter switching device 90 shown in Fig. 32A, for example, is disposed at the light incident side or the light emission side of the fly's-eye lens 37 shown in Fig. 11. This filter switching device 90 is comprised of the rotary disk 92 and a rotary drive shaft 94 for driving the same. The rotary disk 92 has formed on it, along the peripheral direction, a light transmitting opening 95, a filter 96, and other filters. The filter 96, for example as shown in Fig. 30A, blocks light in a range of 0.5 from the center portion when the outer diameter is 1.0.

When a single total exposure time is 1 second, in the initial 0.2 second, the exposure light is passed through the opening 95 shown in Fig. 32A, then the rotary disk 92 is rotated instantaneously and the exposure light is passed through the filter 96 for exposure in the remaining 0.8 second. As a result, as shown in Fig. 31, the distribution of the intensity of the light from the effective light source per single exposure time becomes equal to the distribution of the intensity of light of the sum of the product of the distribution of the intensity of light shown in Fig. 29 and time and the product of the distribution of the intensity of light shown in Fig. 30A and time.

Accordingly, in this example as well, the distribution of the intensity of light of the light source can give a certain degree of intensity of light at the center portion of the light source while emphasizing the two-beam component and enables enlargement of the depth of focus of the dense pattern without affecting isolated patterns.

In this example, a halftone phase shifting mask was used as the mask. Further, the total exposure time is not limited to one second. It may be made shorter or longer depending on the other conditions.

Example 11

Example 11 is one in which the amount of the light emitted from the center portion of the effective light source is lowered by a certain amount relative to the amount of light emitted from the peripheral portions of the effective light source by passing the light through a first filter with a higher transmittance at the peripheral portions as against the center portion for a time of 0.05 x T to 0.95 x T, when a single exposure time is T, and not passing it through the filter in the remaining exposure time.

In this example, use is made of an exposure device of the basic configuration shown in Fig. 11. In the state where the light is not passed through the filter, the distribution of the intensity of the light incident on the fly's-eye lens used as the effective light source is made the flat distribution of intensity of light shown in Fig. 29.

In this example, the sliding type filter switching device 97 shown in Fig. 32B, for example, is disposed at the light incident side or the light emission side of the fly's-eye lens 37 shown in Fig. 11. This filter switching device 97 is provided with a filter holder 98 which holds a plurality of types of filters 96a to 96d and can slide them at a high speed. The filter 96a, for example as shown in Fig. 30B, blocks light in a range in a cross-like range of a width of 0.35 when the outer diameter is 1.0.

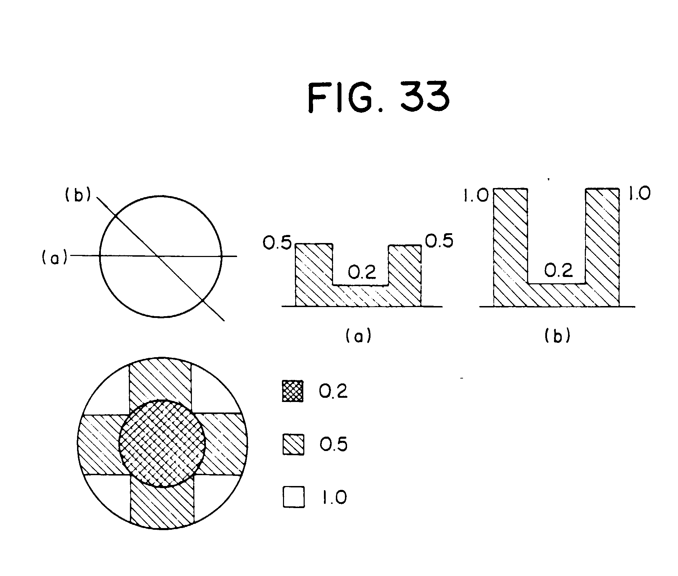

When a single total exposure time is 1 second, in the initial 0.2 second, all of the filters 96a to 96d are retracted in the holder 98 shown in Fig. 32B and exposure light is not passed through any filter. Next, the filter 96a is slid out instantaneously and the exposure light is passed through the filter 96a for exposure for 0.3 second. Next, the filter 96a shown in Fig. 32B is slid back into the holder 98 instantaneously and, simultaneously, the filter 96b is slide out and the exposure light is passed through the filter 96b for exposure in the remaining 0.5 second. As a result, as shown in Fig. 33, the distribution of the intensity of the light from the effective light source per single exposure time becomes equal to the distribution of the intensity of light of the sum of the product of the distribution of the intensity of light shown in Fig. 29 and time and the product of the distribution of the intensity of light shown in Fig. 30B and time.

Accordingly, in this example as well, the distribution of the intensity of light of the light source can give a certain degree of intensity of light at the center portion of the light source while emphasizing the two-beam component and enables enlargement of the depth of focus of the dense pattern without affecting isolated patterns.

In this example, a halftone phase shifting mask was used as the mask. Further, the total exposure time is not limited to one second. It may be made shorter or longer depending on the other conditions.

Example 12

Example 12 is one in which the amount of the light emitted from the center portion of the effective light source is lowered by a certain amount relative to the amount of light emitted from the peripheral portions of the effective light source by passing light through a filter with a variable transmittance and performing exposure while changing the distribution of the light transmittance of the filter midway in a single exposure time.

In this example, use is made of an exposure device of the basic configuration shown in Fig. 11. In the state where the light is not passed through the filter, the distribution of the intensity of the light incident on the fly's-eye lens used as the effective light source is made the flat distribution of intensity of light shown in Fig. 29.

In this example, the optical shutter type optical material 100 shown in Fig. 32C, for example, is disposed at the light incident side or the light emission side of the fly's-eye lens 37 shown in Fig. 11. This optical shutter type optical material is for example comprised of PLZT (lead zirconate titanium dioxide with lanthanum) and is provided with a plurality of fine electrodes on at least one side of its substrate. The light transmittance of this material changes upon application of voltage. By suitably designing the shapes of the electrodes provided on the surface of the optical material 100, it is possible to separately control the central region 102 and the peripheral region 104 and possible to instantaneously block light at just the center portion 102 by applying voltage.

When a single total exposure time is 1 second, in the initial 0.2 second, the center portion 102 and the peripheral portion 104 shown in Fig. 32C are made to transmit light and the exposure light is passed through them. Next, voltage is instantaneously applied to just the electrodes of the center portion 102 to make the center portion 102 block light. The exposure light is passed in this state. As a result, it is possible to obtain similar results as with Example 10.

Note that it is possible to obtain various types of distributions of intensity of light by suitably designing the shapes of the electrodes formed on the surface of the optical material 100, the intervals of their arrangement, and the conditions of application of voltage.

Accordingly, in this example as well, the distribution of the intensity of light of the light source can give a certain degree of intensity of light at the center portion of the light source while emphasizing the two-beam component and enables enlargement of the depth of focus of the dense pattern without affecting isolated patterns.

In this example, a halftone phase shifting mask was used as the mask. Further, the total exposure time is not limited to one second. It may be made shorter or longer depending on the other conditions.

Example 13

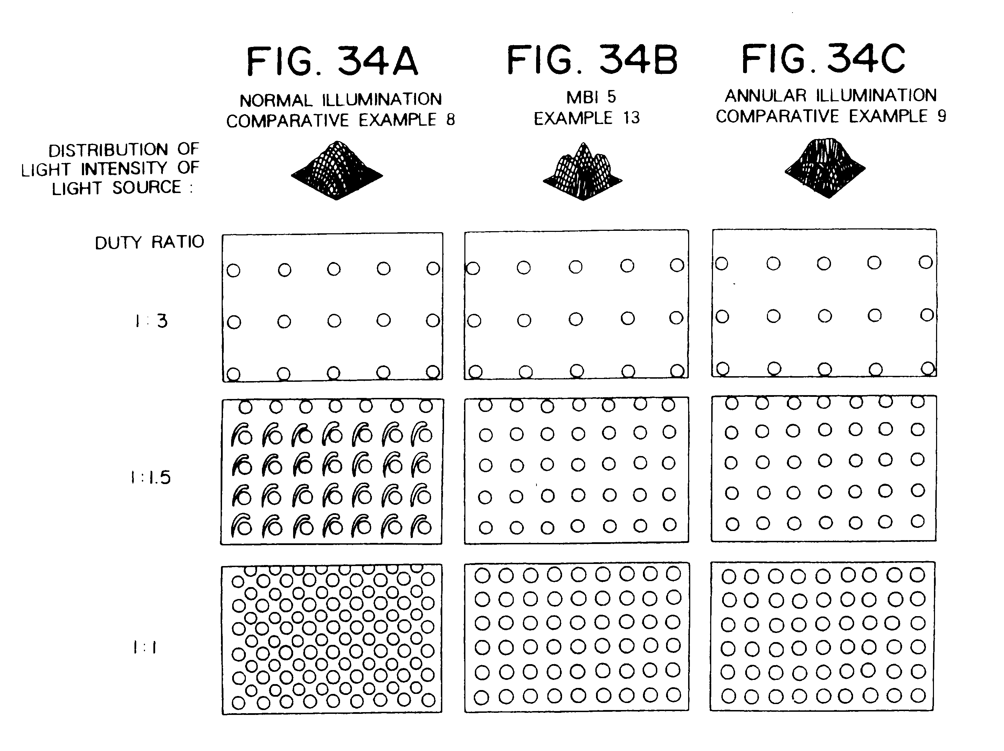

This example is one in which use is made of any of the multiple exposures shown in Examples 10 to 12 to obtain the effective light source of the distribution of the intensity of light shown in Fig. 34B.

Using an effective light source with a low intensity of light at the center portion, a halftone phase shifting mask, and a KrF excimer laser stepper of a numerical aperture of 0.45, contact hole patterns of inside diameters of $0.30 \, \mu m$ were formed on substrates. As the resist, use was made of a chemically amplified positive resist (WKR-PT2). The contact hole patterns were formed changing the ratio between the inside diameter of the contact holes and the intervals between them (duty ratio) to 1:3, 1:1.5, and 1:1. The results of SEM photographs are shown in Fig. 34B.

As Comparative Example 8, the same procedure was performed as in Example 13, except that the distribution of the intensity of light irradiated on the fly's-eye lens was made the Gaussian distribution shown in Fig. 34A, to form contact hole patterns under three sets of conditions. The results of observation by SEM photographs, performed in the same way as in Example 13, are shown in Fig. 34A. In patterns with densely arranged holes, holes caused by the secondary peak ended up being formed.

Further, as Comparative Example 9, the same procedure was followed as in Example 13, except that the distribution of the intensity of the light irradiated on the fly's-eye lens was made a distribution of an annular illumination (the intensity of the light at the center portion of 0), to form a contact hole pattern under three sets of conditions. The results of examination by SEM photographs in the same way as in Example 9 are shown in Fig. 34C.

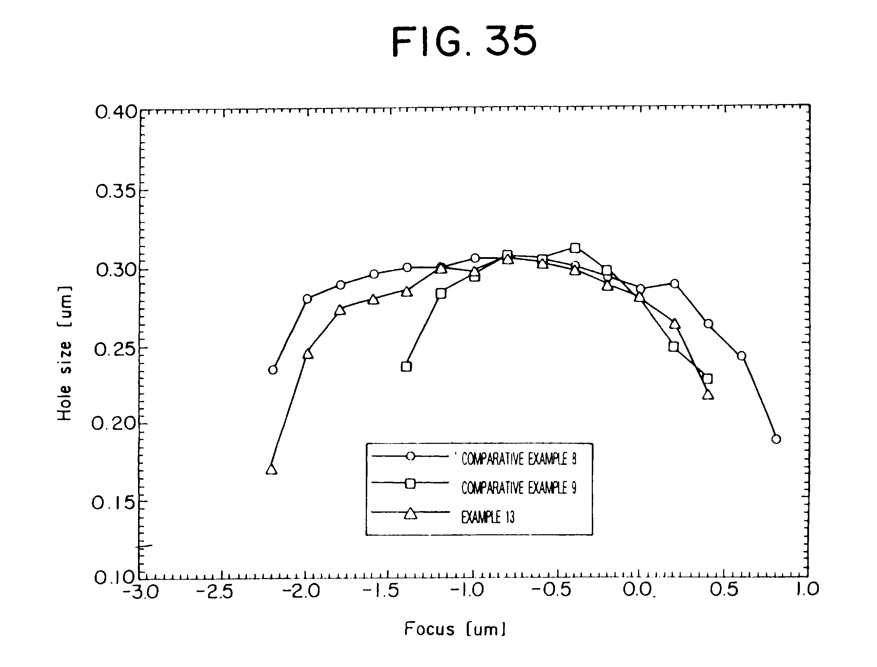

Further, the results of measurement of the depth of focus of the isolate pattern in Example 13 and Comparative Examples 8 and 9 are shown in Fig. 35. In Example 13, it was confirmed, a depth of focus equal to the normal illumination of Comparative Example 8 was secured.

According to the present invention, at the time of a fabrication of a semiconductor device, even if the mask pattern is fine, a device pattern can be formed well with a necessary sufficient depth of focus.

**Claims**

1. A method of pattern formation comprising the steps of irradiating light from an effective light source (37) said effective light source being a fly's eye lens (37) comprising an assembly of a plurality of lenses,
   characterised in that

   said light is irradiated from said effective light source (37) to a phase shifting mask (39)
   the pattern of the mask is transferred onto a substrate (41),
   and the pattern is formed on the substrate,
   wherein the amount of light emitted from a center portion of said effective light source (37) is lowered by 2 to 90 percent with respect to the peak value of the amount of light emitted from the peripheral portions of the effective light source, whereby an oblique incident component is emphasised to an extent that a secondary peak is not generated.

2. The method of pattern formation as set forth in claim 1, wherein the region of the center portion of said effective light source (37) where the amount of light is lowered is a region of 20 to 70 percent of the outer diameter of the effective light source.

3. The method of pattern formation as set forth in claim 1 or 2, wherein the peak of the amount of light at the peripheral portions of said effective light source (37) appears at a few points at rotationally symmetrical positions at the peripheral portions of the effective light source.

4. The method of pattern formation as set forth in any of claims 1 to 3, wherein the amount of light incident upon the center portion of said effective light source (37) is lowered in relation to the peak value of the amount of light incident upon the peripheral portions of the effective light source by using an optical element.

5. The method of pattern formation as set forth in claim 4, wherein the optical element is a beam splitter (35) and/or prism lens.

6. The method of pattern formation as set forth in any of claims 1 to 3, wherein the amount of light emitted from a center portion of said fly's eye lens is lowered by using a beam splitter (35) and/or prism lens.

7. The method of pattern formation as set forth in any of claims 1 to 3, wherein the amount of the light incident upon the center portion of the effective light source (37) is lowered with respect to the peak value of the amount of light incident at the peripheral portions of the effective light source by using a filter (60;100) having a high transmittance at the peripheral portions as against the center portion.

8. The method of pattern formation as set forth in any of claims 1 to 3, which lowers the amount of light emitted from the center portion of said fly's eye lens (37) relative to the peak value of the amount of light emitted from the peripheral portions of the fly's eye lens (37) by using a mechanical filter (60) having opening portions corresponding to the individual lenses of the fly's-eye lens and having diameters of the related opening portions larger at the peripheral portions relative to the center portion.

9. The method of pattern formation as set forth in any of claims 1 to 3, which lowers the amount of light incident upon the center portion of said effective light source (37) relative to the peak value of the amount of light incident upon the peripheral portions of the effective light source by using an optical element (70) and optical parts (72) arranged so that they can be made to approach or move away from each other in the light path axis direction.

10. The method of pattern formation as set forth in claim 9, wherein the optical element is a prism (70).

11. The method of pattern formation as set forth in any of claims 1 to 3, which lowers the amount of light emitted from the center portion of said effective light source (37) relative to the peak value of the amount of light emitted from the peripheral portions of the effective light source by dividing the beam incident upon said effective light source to two or more beams, irradiating the two or more divided beams onto said effective light source by using a movable mirror, and utilizing the difference in scanning speed at respective points of the surface of the effective light source dependent upon the surface shape of said movable mirror.

12. The method of pattern formation as set forth in any of claims 1 to 11, wherein the diameters of the individual lenses of the fly's eye lens (37) are larger at the center portion than the peripheral portions.

13. The method of pattern formation as set forth in claim 12, wherein, in the fly's eye lens (37), the diameters of the individual lenses at the center portion are made 1.1 to 3 times the diameters of the individual lenses at the peripheral portions.

14. The method of pattern formation as set forth in any of claims 1 to 3, which, when a single exposure time is T, passes the light through a first filter (96;96a) with a higher transmittance at the peripheral portions than the center portion for a time of 0.05 x T to 0.95 x T and passes the light through a second filter (96b/96c/96d) or does not pass the light through any filters in the remaining exposure time, thereby lowering the amount of light from the center portion of the effective light source (37) relative to the peak value of the amount of light emitted from the peripheral portions of the effective light source in just a single exposure time.

15. An apparatus for pattern formation irradiating light from an effective light source (37) said effective light source being a fly's eye lens (37) comprising an assembly of a plurality of lenses,
characterised in that

said light is irradiated from an effective light source (37) to a phase shifting mask (39),
the pattern of the mask is transferred onto a substrate (41),
and the pattern is formed on the substrate,
comprising a light intensity distribution correcting means for lowering the amount of light emitted from a center portion of said effective light source by 2 to 90 percent with respect to the peak value of the amount of light emitted from the peripheral portions of the effective light source, whereby an oblique incident component is emphasised to an extent that a secondary peak is not generated.

16. The apparatus for pattern formation as set forth in claim 15, wherein the region of the center portion of said effective light source (37) where the amount of light is lowered by the light intensity distribution correcting means is a region of 20 to 40 percent of the outer diameter of the effective light source.

17. The apparatus for pattern formation as set forth in claim 15 or 16, wherein the peak of the amount of light at the peripheral portions of said effective light source (37) appears at a few points at rotationally symmetrical positions at the peripheral portions of the effective light source.

18. The apparatus for pattern formation as set forth in any of claims 15 to 17, wherein the light intensity distribution correcting means has an optical element which lowers the amount of light incident upon the center portion of the effective light source (37) in relation to the peak value of the amount of light incident upon the peripheral portions of the effective light source.

19. The apparatus for pattern formation as set forth in claim 18, wherein the optical element is a beam splitter (35) and/or a prism lens.

20. The apparatus for pattern formation as set forth in any of claims 15 to 18, wherein the light intensity distribution correcting means has a filter (60;100) having a high transmittance at the peripheral portions as against the center portion.

21. The apparatus for pattern formation as set forth in any of claims 15 to 17, wherein the light intensity distribution correcting means has a mechanical filter (60), which mechanical filter has opening portions corresponding to the individual lenses of the fly's-eye lens (37) and has diameters of the related opening portions larger at the peripheral portions relative to the center portion.

22. The apparatus for pattern formation as set forth in any of claims 15 to 17, wherein the light intensity distribution correcting means has an optical element (70) and optical parts (72) arranged so that they can be made to approach or move away from this optical element in the light path axis direction.

23. The apparatus for pattern formation as set forth in claim 22, wherein the optical element is a prism (70).

24. The apparatus for pattern formation as set forth in any of claims 15 to 17, wherein the light intensity distribution correcting means further has means for dividing the beam incident upon said effective light source (37) to two or more beams, a movable mirror for irradiating the two or more divided beams onto said effective light source (37), and scan means for lowering the amount of light emitted from the center portion of said effective light source relative to the peak value of the amount of light emitted from the peripheral portions of the effective light source by using the difference in scanning speed at respective points of the surface of the effective light source dependent upon the surface shape of said movable mirror.

25. The apparatus for pattern formation as set forth in any of claims 15 to 24, wherein the diameters of the individual lens of the fly's-eye lens (37) are larger at the center portion as against the peripheral portions.

26. The apparatus for pattern formation as set forth in claim 25, wherein, in the fly's-eye lens (37), the diameters of the individual lenses at the center portion are 1.1 to 3 times the diameters of the individual lenses at the peripheral portions.

27. The apparatus for pattern formation as set forth in any of claims 15 to 17, wherein the light intensity distribution correcting means also has

   a first filter (96;100;96a) with a higher transmittance at the peripheral portions than the center portion and
   a switching means (90-94;97,98) for switching between a state passing light through the first filter for a single exposure time and a state performing exposure without passing through the first filter.

28. The apparatus for pattern formation as set forth in claim 27, which further has a second filter (96b/96c/96d) with a distribution of transmittance different from the first filter and causes the light to pass through the second filter in the state performing exposure without passing through the first filter.

29. The apparatus for pattern formation as set forth in claim 27 or 28, wherein the switching means has a rotary disk (92) on which at least the first filter (96) is mounted and a drive means (94) for driving the rotation of the rotary disk.

30. The apparatus for pattern formation as set forth in claim 27 or 28, wherein the switching means has at slide mechanism (98) enabling at least the first filter (96a) to move slidably.

31. The apparatus for pattern formation as set forth in claim 27 or 28, wherein the switching means has an optical shutter type optical material (100) whose transmittance of light changes according to the voltage applied.

32. A method of production of a semiconductor device comprising the method of pattern formation as set forth in claims 1 to 14.

**Patentansprüche**

1. Verfahren zur Musterbildung, welches die Schritte zum Strahlen von Licht von einer wirksamen Lichtquelle (37) umfaßt, wobei die wirksame Lichtquelle eine Facettenlinse (37) ist, die eine Baugruppe von mehreren Linsen umfaßt,

dadurch gekennzeichnet, daß

das Licht von der wirksamen Lichtquelle (37) auf eine Phasenverschiebungsmaske (39) gestrahlt wird,
das Muster der Maske auf ein Substrat (41) übertragen wird,
und das Muster auf dem Substrat gebildet wird,
wobei die Lichtmenge, die von einem Mittelbereich der wirksamen Lichtquelle (37) emittiert wird, um 2 bis 90% in bezug auf den Spitzenwert der Lichtmenge abgesenkt wird, die von den Umfangsbereichen der wirksamen Lichtquelle emittiert wird, wodurch eine Schrägeinfall-Komponente bis zu einem Maß angehoben wird, daß eine Sekundärspitze nicht erzeugt wird.

2. Verfahren zur Musterbildung nach Anspruch 1, wobei der Bereich des Mittelbereichs der wirksamen Lichtquelle (37), wo die Lichtmenge abgesenkt wird, ein Bereich von 20 bis 70% des Außendurchmessers der wirksamen Lichtquelle ist.

3. Verfahren zur Musterbildung nach Anspruch 1 oder 2, wobei der Spitzenwert der Lichtmenge an den Umfangsbereichen der wirksamen Lichtquelle (37) bei wenigen Punkten bei rotations-symmetrischen Positionen an den Umfangsbereichen der wirksamen Lichtquelle auftritt.

4. Verfahren zur Musterbildung nach einem der Ansprüche 1 bis 3, wobei die Lichtmenge, die auf den Mittelbereich der wirksamen Lichtquelle (37) auftrifft, in bezug auf den Spitzenwert der Lichtmenge, die auf die Umfangsbereiche der wirksamen Lichtquelle auftrifft, unter Verwendung eines optischen Elements abgesenkt wird.

5. Verfahren zur Musterbildung nach Anspruch 4, wobei das optische Element ein Strahlenteiler (35) und/oder eine Prismenlinse ist.

6. Verfahren zur Musterbildung nach einem der Ansprüche 1 bis 3, wobei die Lichtmenge, die von einem Mittelbereich der Facettenlinse emittiert wird, unter Verwendung eines Strahlenteilers (35) und/oder einer Prismenlinse abgesenkt wird.

7. Verfahren zur Musterbildung nach einem der Ansprüche 1 bis 3, wobei die Lichtmenge, die auf den Mittelbereich der wirksamen Lichtquelle (37) auftrifft, in bezug auf den Spitzenwert der Lichtmenge, die auf die Umfangsbereiche der wirksamen Lichtquelle auftrifft, unter Verwendung eines Filters (60; 100) abgesenkt wird, welches einen hohen Durchlässigkeitsfaktor an den Umfangsbereichen verglichen mit dem Mittelbereich hat.

8. Verfahren zur Musterbildung nach einem der Ansprüche 1 bis 3, welches die Lichtmenge, die vom Mittelbereich der Facettenlinse (37) emittiert wird, in bezug auf den Spitzenwert der Lichtmenge, die von den Umfangsbereichen der Facettenlinse (37) emittiert wird, absenkt, wobei ein mechanisches Filter (60) verwendet wird, welches Öffnungsbereiche besitzt, die den individuellen Linsen der Facettenlinse entsprechen und die Durchmesser der bezogenen Öffnungsbereiche haben, die an den Umfangsbereichen in bezug auf den Mittelbereich größer sind.

9. Verfahren zur Musterbildung nach einem der Ansprüche 1 bis 3, welches die Lichtmenge, die auf den Mittelbereich der wirksamen Lichtquelle (37) auftrifft, in bezug auf den Spitzenwert der Lichtquelle, die auf die Umfangsbereiche der wirksamen Lichtquelle auftrifft, absenkt, wobei ein optisches Element (70) und optische Teile (72) verwendet werden, die so angeordnet sind, damit sie sich in der Lichtpfadachsenrichtung einander annähern oder voneinander weg bewegen können.

10. Verfahren zur Musterbildung nach Anspruch 9, wobei das optische Element ein Prisma (70) ist.

11. Verfahren zur Musterbildung nach einem der Ansprüche 1 bis 3, welches die Lichtmenge, die vom Mittelbereich der wirksamen Lichtquelle (37) emittiert wird, in bezug auf den Spitzenwert der Lichtmenge, die von den Umfangsbereichen der wirksamen Lichtquelle emittiert wird, absenkt, wobei der Strahl, der auf die wirksame Lichtquelle fällt, in zwei oder mehrere Strahlen unterteilt wird, die beiden oder mehreren unterteilten Strahlen auf die wirksame Lichtquelle gestrahlt werden, wobei ein bewegbarer Spiegel verwendet wird, und die Differenz der Abtastgeschwindigkeit an entsprechenden Punkten der Oberfläche Gier wirksamen Lichtquelle in Abhängigkeit von der Flächenform des bewegbaren Spiegels verwendet wird.

12. Verfahren zur Musterbildung nach einem der Ansprüche 1 bis 11, wobei der Durchmesser der individuellen Linsen der Facettenlinse (37) am Mittelbereich größer ist ais am Umfangsbereich.

13. Verfahren zur Musterbildung nach Anspruch 12, wobei bei der Facettenlinse (37) der Durchmesser der individuellen Linsen am Mittelbereich das 1,1- bis 3-fache des Durchmessers der individuellen Linsen am Umfangsbereich beträgt .

14. Verfahren zur Musterbildung nach einem der Ansprüche 1 bis 3, welches, wenn eine Einzelbelichtungszeit T ist, das Licht durch ein erstes Filter (96; 96a) mit einem höheren Durchlässigkeitsfaktor an den Umfangsbereichen als am Mittelbereich für eine Zeitdauer von 0,05 x T bis 0,95 x T durchläßt, und das Licht durch ein zweites Filter (96b/96c/96d) durchläßt oder das Licht durch irgendwelche Filter in der verbleibenden Belichtungszeit nicht durchläßt, wodurch die Lichtmenge vom Mittelbereich der wirksamen Lichtquelle (37) in bezug auf den Spitzenwert der Lichtmenge, die von den Umfangsbereichen der wirksamen Lichtquelle emittiert wird, in einer Einzelbelichtungszeit abgesenkt wird.

15. Gerät zur Musterbildung, wobei Licht von einer wirksamen Lichtquelle (37) abgestrahlt wird, wobei die wirksame Lichtquelle eine Facettenlinse (37) ist, die eine Baugruppe von mehreren Linsen umfaßt,
        dadurch gekennzeichnet, daß

        das Licht von der wirksamen Lichtquelle (37) zu einer Phasenverschiebungsmaske (39) gestrahlt wird,
        das Muster der Maske auf ein Substrat (41) übertragen wird,
        und das Muster auf dem Substrat gebildet wird,
        mit einer Lichtintensitätsverteilungs-Korrektureinrichtung, um die Lichtmenge, die von einem Mittelbereich der wirksamen Lichtquelle emittiert wird, um 2 bis 90% in bezug auf den Spitzenwert der Lichtmenge abzusenken, die von den Umfangsbereichen der wirkamen Lichtquelle emittiert wird, wodurch eine Schrägeinfallskomponente bis zu einem Maß angehoben wird, daß eine Sekundärspitze nicht erzeugt wird.

16. Gerät zur Musterbildung nach Anspruch 15, wobei der Bereich des Mittelbereichs der wirksamen Lichtquelle (37), wo die Lichtmenge durch die Lichtintensitätsverteilungs-Korrektureinrichtung abgesenkt wird, ein Bereich von 20 bis 40% des Außendurchmessers der wirksamen Lichtquelle ist.

17. Gerät zur Musterbildung nach Anspruch 15 oder 16, wobei der Spitzenwert der Lichtmenge an den Umfangsbereichen der wirksamen Lichtquelle (37) an wenigen Punkten bei rotations-symmetrischen Positionen an den Umfangsbereichen der wirksamen Lichtquelle auftritt.

18. Gerät zur Musterbildung nach einem der Ansprüche 15 bis 17, wobei die Lichtintensitätsverteilungs-Korrektureinrichtung ein optisches Element aufweist, welches die Lichtmenge, die auf den Mittelbereich der wirksamen Lichtquelle (37) auftrifft, in bezug auf den Spitzenwert der Lichtmenge, die auf die Umfangsbereiche der wirksamen Lichtquelle auftrifft, absenkt.

**19.** Gerät zur Musterbildung nach Anspruch 18, wobei das optische Element ein Strahlenteiler (35) und/oder eine Prismenlinse ist.

**20.** Gerät zur Musterbildung nach einem der Ansprüche 15 bis 18, wobei die Lichtintensitätsverteilungs-Korrektureinrichtung ein Filter (60; 100) besitzt, welches einen hohen Durchlässigkeitsfaktor an den Umfangsbereichen verglichen mit dem Mittelbereich hat.

**21.** Gerät zur Musterbildung nach einem der Ansprüche 15 bis 17, wobei die Lichtintensitätsverteilungs-Korrektureinrichtung ein mechanisches Filter (60) aufweist, wobei das mechanische Filter Öffnungsbereiche hat, die den individuellen Linsen der Facettenlinse (37) entsprechen, und Durchmesser der bezogenen Öffnungsbereiche hat, die an den Umfangsbereichen in bezug auf den Mittelbereich größer sind.

**22.** Gerät zur Musterbildung nach einem der Ansprüche 15 bis 17, wobei die Lichtintensitätsverteilungs-Korrektureinrichtung ein optisches Element (70) und optische Teile (72) hat, die so angeordnet sind, daß sie sich diesem optischen Element in der Lichtpfad-Achsenrichtung annähern oder sich davon weg bewegen können.

**23.** Gerät zur Musterbildung nach Anspruch 22, wobei das optische Element ein Prisma (70) ist.

**24.** Gerät zur Musterbildung nach einem der Ansprüche 15 bis 17, wobei die Lichtintensitätsverteilungs-Korrektureinrichtung außerdem eine Einrichtung zum Unterteilen des Strahls, der auf die wirksame Lichtquelle (37) auftrifft, in zwei oder mehrere Strahlen, einen bewegbaren Spiegel, um die zwei oder mehreren unterteilten Strahlen auf die wirksame Lichtquelle (37) zu strahlen, und eine Abtasteinrichtung aufweist, um die Lichtmenge, die vom Mittelbereich der wirksamen Lichtquelle emittiert wird, in bezug auf den Spitzenwert der Lichtmenge, die von dem Umfangsbereichen der wirksamen Lichtquelle emittiert wird, abzusenken, wobei die Differenz der Abtastgeschwindigkeit an entsprechenden Punkten der Fläche der wirksamen Lichtquelle in Abhängigkeit von der Flächenform des bewegbaren Spiegels verwendet wird.

**25.** Gerät zur Musterbildung nach einem der Ansprüche 15 bis 24, wobei der Durchmesser der individuellen Linsen der Facettenlinse (37) am Mittelbereich verglichen mit den Umfangsbereichen größer sind.

**26.** Gerät zur Musterbildung nach Anspruch 25, wobei bei der Facettenlinse (37) der Durchmesser der individuellen Linsen am Mittelbereich das 1,1- bis 3-fache des Durchmessers der individuellen Linsen an den Umfangsbereichen ist.

**27.** Gerät zur Musterbildung nach einem der Ansprüche 15 bis 17, wobei die Lichtintensitätsverteilungs-Korrektureinrichtung außerdem aufweist:

ein erstes Filter (96; 100; 96a) mit einem höheren Durchlässigkeitsfaktor an den Umfangsbereichen als am Mittelbereich, und

eine Umschalteinrichtung (90-94; 97, 98), um zwischen einem Zustand umzuschalten, bei dem Licht durch das erste Filter für eine Einzelbelichtungszeit läuft, und einem Zustand, bei dem eine Belichtung durchgeführt wird, ohne durch das erste Filter zu laufen.

**28.** Gerät zur Musterbildung nach Anspruch 27, welches außerdem ein zweites Filter (96b, 96c, 96d) mit einer Durchlässigkeitsfaktor-Verteilung hat, die gegenüber dem ersten Filter verschieden ist und die bewirkt, daß Licht durch das zweite Filter in dem Zustand läuft, bei dem die Belichtung durchgeführt wird, ohne durch das erste Filter zu laufen.

**29.** Gerät zur Musterbildung nach Anspruch 27 oder 28, wobei die Umschalteinrichtung eine Drehplatte (92) aufweist, auf welcher zumindest das erste Filter (96) befestigt ist, und eine Antriebseinrichtung (94), um die Drehplatte drehbar anzutreiben.

**30.** Gerät zur Musterbildung nach Anspruch 27 oder 28, wobei die Umschalteinrichtung einen Schlittenmechanismus (98) aufweist, der ermöglicht, daß zumindest das erste Filter (96a) sich verschiebbar bewegt.

**31.** Gerät zur Musterbildung nach Anspruch 27 oder 28, wobei die Umschalteinrichtung ein optische Blende aus einem optischen Material (100) besitzt, deren Lichtdurchlässigkeitsfaktor sich gemäß der angelegten Spannung ändert.

**32.** Verfahren zur Herstellung einer Halbleitereinrichtung, welches das Verfahren zur Musterbildung nach den Patentansprüchen 1 - 14 umfaßt.

**Revendications**

**1.** Procédé de formation de motif comprenant les étapes d'irradiation d'une lumière depuis une source de lumière effective (37), ladite source de lumière effective étant un objectif en oeil de mouche (37) comprenant un assemblage d'une pluralité de lentilles,
caractérisé en ce que :

ladite lumière est irradiée depuis ladite source de lumière effective (37) sur un masque de décalage de phase (39) ;
le motif du masque est transféré sur un substrat (41) ; et
le motif est formé sur le substrat,
dans lequel la quantité de lumière émise depuis une partie centrale de ladite source de lumière effective (37) est abaissée de 2 à 90 % par rapport à la valeur de pic de la quantité de lumière émise depuis les parties périphériques de la source de lumière effective et ainsi, une composante d'incidence oblique est accentuée jusqu'à un point où un pic secondaire n'est pas généré.

**2.** Procédé de formation de motif selon la revendication 1, dans lequel la région de la partie centrale de ladite source de lumière effective (37) où la quantité de lumière est abaissée est une région de 20 à 70 % du diamètre externe de la source de lumière effective.

**3.** Procédé de formation de motif selon la revendication 1 ou 2, dans lequel le pic de la quantité de lumière au niveau des parties périphériques de ladite source de lumière effective (37) apparaît en quelques points en des positions en symétrie de rotation au niveau des parties périphériques de la source de lumière effective.

**4.** Procédé de formation de motif selon l'une quelconque des revendications 1 à 3, dans lequel la quantité de lumière qui arrive en incidence sur la partie centrale de ladite source de lumière effective (37) est abaissée par rapport à la valeur de pic de la quantité de lumière qui arrive en incidence sur les parties périphériques de la source de lumière effective en utilisant un élément optique.

**5.** Procédé de formation de motif selon la revendication 4, dans lequel l'élément optique est un séparateur de faisceau (35) et/ou une lentille en prisme.

**6.** Procédé de formation de motif selon l'une quelconque des revendications 1 à 3, dans lequel la quantité de lumière émise depuis une partie centrale dudit objectif en oeil de mouche est abaissée en utilisant un séparateur de faisceau (35) et/ou une lentille en prisme.

**7.** Procédé de formation de motif selon l'une quelconque des revendications 1 à 3, dans lequel la quantité de lumière qui arrive en incidence sur la partie centrale de la source de lumière effective (37) est abaissée par rapport à la valeur de pic de la quantité de lumière qui arrive en incidence au niveau des parties périphériques de la source de lumière effective en utilisant un filtre (60 ; 100) présentant une transmittance élevée au niveau des parties périphériques par comparaison avec la partie centrale.

**8.** Procédé de formation de motif selon l'une quelconque des revendications 1 à 3, qui abaisse la quantité de lumière émise depuis la partie centrale dudit objectif en oeil de mouche (37) par rapport à la valeur de pic de la quantité de lumière qui est émise depuis les parties périphériques de l'objectif en oeil de mouche (37) en utilisant un filtre mécanique (60) comportant des parties d'ouverture correspondant aux lentilles individuelles de l'objectif en oeil de mouche et présentant des diamètres des parties d'ouverture afférentes plus grands au niveau des parties périphériques qu'au niveau de la partie centrale.

**9.** Procédé de formation de motif selon l'une quelconque des revendications 1 à 3, qui abaisse la quantité de lumière qui arrive en incidence sur la partie centrale de ladite source de lumière effective (37) par rapport à la valeur de pic de la quantité de lumière qui arrive en incidence sur les parties périphériques de la source de lumière effective en utilisant un élément optique (70) et des parties optiques (72) agencées de telle sorte qu'elles puissent être amenées à s'approcher ou à s'éloigner les unes des autres suivant la direction d'axe de chemin lumineux.

**10.** Procédé de formation de motif selon la revendication 9, dans lequel l'élément optique est un prisme (70).

**11.** Procédé de formation de motif selon l'une quelconque des revendications 1 à 3, qui abaisse la quantité de lumière émise depuis la partie centrale de ladite source de lumière effective (37) par rapport à la valeur de pic de la quantité de lumière émise depuis les parties périphériques de la source de lumière effective en divisant le faisceau qui arrive en incidence sur ladite source de lumière effective selon deux faisceaux ou plus, en irradiant les deux faisceaux ou plus divisés sur ladite source de lumière effective en utilisant un miroir mobile et en utilisant la différence en termes de vitesse de balayage en des points respectifs de la surface de la source de lumière effective en fonction de la forme de surface dudit miroir mobile.

**12.** Procédé de formation de motif selon l'une quelconque des revendications 1 à 11, dans lequel les diamètres des lentilles individuelles de l'objectif en oeil de mouche (37) sont plus grands au niveau de la partie centrale qu'au niveau des parties périphériques.

**13.** Procédé de formation de motif selon la revendication 12, dans lequel, dans l'objectif en oeil de mouche (37), les diamètres des lentilles individuelles au niveau de la partie centrale sont rendus égaux à 1,1 à 3 fois les diamètres des lentilles individuelles au niveau des parties périphériques.

**14.** Procédé de formation de motif selon l'une quelconque des revendications 1 à 3, qui, lorsqu'un temps d'exposition unique vaut T, laisse passer la lumière au travers d'un premier filtre (96 ; 96a) selon une transmittance plus élevée au niveau des parties périphériques qu'au niveau de la partie centrale pendant un temps de 0,05 x T à 0,95 x T et laisse passer la lumière au travers d'un second filtre (96b / 96c / 96d) ou ne laisse pas passer la lumière au travers de quelconques filtres dans le temps d'exposition restant, pour ainsi abaisser la quantité de lumière en provenance de la partie centrale de la source de lumière effective (37) par rapport à la valeur de pic de la quantité de lumière émise depuis les parties périphériques de la source de lumière effective en juste un temps d'exposition unique.

**15.** Appareil pour une formation de motif qui irradie une lumière en provenance d'une source de lumière effective (37), ladite source de lumière effective étant un objectif en oeil de mouche (37) comprenant un assemblage d'une pluralité de lentilles,

caractérisé en ce que :

ladite lumière est irradiée depuis une source de lumière effective (37) sur un masque de décalage de phase (39) ;
le motif du masque est transféré sur un substrat (41) ; et
le motif est formé sur le substrat,
comprenant un moyen de correction de distribution d'intensité de lumière pour abaisser la quantité de lumière émise depuis une partie centrale de ladite source de lumière effective de 2 à 90 % par rapport à la valeur de pic de la quantité de lumière émise depuis les parties périphériques de la source de lumière effective et ainsi, une composante d'incidence oblique est accentuée jusqu'à un point où un pic secondaire n'est pas généré.

**16.** Appareil pour une formation de motif selon la revendication 15, dans lequel la région de la partie centrale de ladite source de lumière effective (37) où la quantité de lumière est abaissée par le moyen de correction de distribution d'intensité lumineuse est une région de 20 à 40 % du diamètre externe de la source de lumière effective.

**17.** Appareil pour une formation de motif selon la revendication 15 ou 16, dans lequel le pic de la quantité de lumière au niveau des parties périphériques de ladite source de lumière effective (37) apparaît en quelques points en des positions en symétrie de rotation au niveau des parties périphériques de la source de lumière effective.

**18.** Appareil pour une formation de motif selon l'une quelconque des revendications 15 à 17, dans lequel le moyen de correction de distribution d'intensité lumineuse comporte un élément optique qui abaisse la quantité de lumière qui arrive en incidence sur la partie centrale de la source de lumière effective (37) en relation avec la valeur de pic de la quantité de lumière qui arrive en incidence sur les parties périphériques de la source de lumière effective.

**19.** Appareil pour une formation de motif selon la revendication 18, dans lequel l'élément optique est un séparateur de faisceau (35) et/ou une lentille en prisme.

**20.** Appareil pour une formation de motif selon l'une quelconque des revendications 15 à 18, dans lequel le moyen de correction de distribution d'intensité lumineuse comporte un filtre (60 ; 100) présentant une transmittance élevée au niveau des parties périphériques par comparaison avec la partie centrale.

21. Appareil pour une formation de motif selon l'une quelconque des revendications 15 à 17, dans lequel le moyen de correction de distribution d'intensité lumineuse comporte un filtre mécanique (60), lequel filtre mécanique comporte des parties d'ouverture correspondant aux lentilles individuelles de l'objectif en oeil de mouche (37) et présente des diamètres des parties d'ouvertures afférentes plus grands au niveau des parties périphériques qu'au niveau de la partie centrale.

22. Appareil pour une formation de motif selon l'une quelconque des revendications 15 à 17, dans lequel le moyen de correction de distribution d'intensité lumineuse comporte un élément optique (70) et des parties optiques (72) agencées de telle sorte qu'elles puissent être amenées à s'approcher ou à s'éloigner de cet élément optique suivant la direction d'axe de chemin lumineux.

23. Appareil pour une formation de motif selon la revendication 22, dans lequel l'élément optique est un prisme (70).

24. Appareil pour une formation de motif selon l'une quelconque des revendications 15 à 17, dans lequel le moyen de correction de distribution d'intensité lumineuse comporte en outre un moyen pour diviser le faisceau qui arrive en incidence sur ladite source de lumière effective (37) selon deux faisceaux ou plus, un miroir mobile pour irradier les deux faisceaux divisés ou plus sur ladite source de lumière effective (37) et un moyen de balayage pour abaisser la quantité de lumière émise depuis la partie centrale de ladite source de lumière effective par rapport à la valeur de pic de la quantité de lumière émise depuis les parties périphériques de la source de lumière effective en utilisant la différence en termes de vitesse de balayage en des points respectifs de la surface de la source de lumière effective en fonction de la forme de surface dudit miroir mobile.

25. Appareil pour une formation de motif selon l'une quelconque des revendications 15 à 24, dans lequel les diamètres des lentilles individuelles de l'objectif en oeil de mouche (37) sont plus grands au niveau de la partie centrale qu'au niveau des parties périphériques.

26. Appareil pour une formation de motif selon la revendication 25, dans lequel, dans l'objectif en oeil de mouche (37), les diamètres des lentilles individuelles au niveau de la partie centrale sont égaux à 1,1 à 3 fois les diamètres des lentilles individuelles au niveau des parties périphériques.

27. Appareil pour une formation de motif selon l'une quelconque des revendications 15 à 17, dans lequel le moyen de correction de distribution d'intensité lumineuse comporte également :

un premier filtre (96 ;100 ; 96a) présentant une transmittance plus élevée au niveau des parties périphériques qu'au niveau de la partie centrale ; et
un moyen de commutation (90-94 ; 97, 98) pour réaliser une commutation entre un état qui laisse passer la lumière au travers du premier filtre pendant un temps d'exposition unique et un état qui réalise une exposition sans passage au travers du premier filtre.

28. Appareil pour une formation de motif selon la revendication 27, qui comporte en outre un second filtre (96b / 96c / 96d) présentant une distribution de transmittance différente de celle du premier filtre et qui force la lumière à passer au travers du second filtre dans l'état qui réalise une exposition sans passage au travers du premier filtre.

29. Appareil pour une formation de motif selon la revendication 27 ou 28, dans lequel le moyen de commutation comporte un disque tournant (92) sur lequel au moins le premier filtre (96) est monté et un moyen d'entraînement (94) pour entraîner en rotation le disque tournant.

30. Appareil pour une formation de motif selon la revendication 27 ou 28, dans lequel le moyen de commutation comporte un mécanisme de coulisseau (98) qui permet un déplacement coulissant d'au moins le premier filtre (96a).

31. Appareil pour une formation de motif selon la revendication 27 ou 28, dans lequel le moyen de commutation comporte un matériau optique du type obturateur optique (100) dont la transmittance de lumière varie en fonction de la tension appliquée.

32. Procédé de fabrication d'un dispositif à semiconducteur comprenant le procédé de formation de motif selon les revendications 1 à 14.

# F I G.  I

$$d_{PR1} \neq d_{PR2}$$

# F I G. 2 A

CONVENTIONAL EXPOSURE
RESIST : WKR-PT1、0.84 $\mu$ m

# F I G. 2 B

| NECESSARY D.O.F ($\mu$m) | RESOLUTION ($\mu$m) | OPTIMUM NA |
|---|---|---|
| 1.50 | 0.35 | 0.42 |
| 1.20 | 0.30 | 0.48 |
| 1.00 | 0.28 | 0.54 |
| 0.80 | 0.25 | 0.61 |

# FIG. 3

# F I G. 4 A

Cr MASK METHOD
0.6 λ／NA HOLE PATTERN

# F I G. 4 B

HALFTONE PHASE SHIFT METHOD
0.6 λ／NA HOLE PATTERN

# F I G. 5A

# F I G. 5B

FIG. 6

# FIG. 7

CASE OF (II)

−1-TH ORDER     0-TH ORDER     +1-TH ORDER

CASE OF (I)

−1-TH ORDER     0-TH ORDER     +1-TH ORDER

−1-TH ORDER

-CASE OF (IV)

0-TH ORDER     +1-TH ORDER

CASE OF (III)

−1-TH ORDER     0-TH ORDER     +1-TH ORDER

# FIG. 8

# FIG. 9A  FIG. 9B

3-BEAM IMAGE

2-BEAM IMAGE

EP 0 698 824 B1

# FIG. 10 A

# FIG. 10 B

# FIG. 11

35 BEAM SPLITTER

39 RETICLE

30 EXCIMER LASER

LASER SIDE    STEPPER SIDE

38 MASKING BLADE

40 PROJECTION LENS

31 DOSAGE CONTROL UNIT

34 EMISSION OPTICAL SYSTEM

33 SHIFTING UNIT

32 BEAM SHAPE FORMATION UNIT

36 PRISM UNIT

37 FLY' S-EYE LENS

41 WAFER

EP 0 698 824 B1

# FIG. 12 A

ON PRISM

# FIG. 12 B

ON FLY' S-EYE LENS

# FIG. 12 C

# FIG. 13A

Normal + Conv. Mask

# FIG. 13B

Beam + Conv. Mask

# F I G. 14 A

Normal + HT Mask

# F I G. 14 B

Beam + HT Mask

# F I G. 15A

ON PRISM

42

42

42

42

# F I G. 15B

ON FLY'S-EYE LENS

43

43

44

43

43

# FIG. 16

COMPARATIVE EXAMPLE 1

# F I G. 17

EXAMPLE A

# FIG. 18

EXAMPLE B

# F I G. 19

EXAMPLE C

# FIG. 20A

COMPARATIVE EXAMPLE 1

-0.6μm DEFOCUS | BEST FOCUS | +0.6μm DEFOCUS

# FIG. 20B

EXAMPLE C

EP 0 698 824 B1

# FIG. 21A

-0.6μm DEFOCUS     BEST FOCUS     +0.6μm DEFOCUS

52a   50a     52a   50a

COMPARATIVE EXAMPLE 1

50a
52a

# FIG. 21B

EXAMPLE C

50a     50a     50a

EP 0 698 824 B1

# FIG. 22A

[μm]

COMPARATIVE EXAMPLE 1

# FIG. 22B

[μm]

EXAMPLE C

# FIG. 23

37

# FIG. 24

60

# FIG. 25

70

72

# FIG. 26

CELL No   1        2        3        4

# FIG. 27A

( New illumination +Att. PSM )  EXAMPLE 8

# FIG. 27B

( Conventional +Att. PSM )  COMPARATIVE EXAMPLE 4

# FIG. 27C

( Annular +Att. PSM )  COMPARATIVE EXAMPLE 5

FIG. 28B
COMPARATIVE EXAMPLE 6
Conventional

FIG. 28A
New illumination
EXAMPLE 9

FIG. 28C
Annular
COMPARATIVE EXAMPLE 7

# FIG. 29

1.0

0.0

# FIG. 30A

1.0

0.5

# FIG. 30B

1.0

0.35

# FIG. 31

0.2 + 0.8 = 1.0 1.0 0.2

EP 0 698 824 B1

# FIG. 32A

# FIG. 32B

# FIG. 32C

# FIG. 33

(a)

(b)

0.2

0.5

1.0

FIG. 34A

NORMAL ILLUMINATION
COMPARATIVE EXAMPLE 8

FIG. 34B

MBI 5
EXAMPLE 13

FIG. 34C

ANNULAR ILLUMINATION
COMPARATIVE EXAMPLE 9

DISTRIBUTION OF
LIGHT INTENSITY OF
LIGHT SOURCE :

DUTY RATIO

1:3

1:1.5

1:1

EP 0 698 824 B1

# FIG. 35